# EUROPEAN PATENT APPLICATION

(11) **EP 4 497 854 A1**
(43) Date of publication of application: **29.01.2025**
(21) Application number: 23773874.5
(22) Date of filing: 21.03.2023
(51) Int. Cl.: C30B 15/00, C30B 35/00

(54) **CRYSTAL COOLING APPARATUS FOR SIMULTANEOUSLY DRAWING MULTIPLE CRYSTALS AND ARTIFICIAL CRYSTAL PREPARATION DEVICE**

(30) Priority: 21.03.2022 CN 202210278020; 27.09.2022 CN 202211182774; 27.09.2022 CN 202211182775
(71) Applicant: Luoyang Changying New Energy Technology Co., Ltd., Luoyang, Henan 471000 (CN)
(72) Inventor: GUO, Liliang, Luoyang, Henan 471000 (CN); ZHU, Zhenye, Luoyang, Henan 471000 (CN)
(74) Representative: Cabinet Beau de Loménie
(86) International application number: PCT/CN2023/082901
(87) International publication number: WO 2023/179627

(57) **Abstract**

A crystal cooling apparatus for simultaneously pulling multiple crystals and an artificial crystal preparation device. The crystal cooling apparatus is provided with multiple first lift holes for pulled crystals to pass through and a cooling medium channel for cooling the crystals. According to the present application, the pulled crystals can be cooled quickly, and multiple crystals can be pulled at the same time, thereby increasing the speed for pulling silicon core. Moreover, broken silicon material can be used to pull multiple silicon cores at the same time, thus effectively preventing the resource waste of the broken silicon material.

## Description

### Cross-reference to Related Applications

This application claims the benefit of Chinese Patent Application No. 202210278020.X, filed on March 21, 2022, Chinese Patent Application No. 202211182774.1, filed on September 27, 2022, and Chinese Patent Application No. 202211182775.6, filed on September 27, 2022, to China National Intellectual Property Administration, all of which are incorporated herein by reference in their entirety.

### Technical Field

The present application relates to the technical field of artificial crystal preparation, and in particular to a crystal cooling apparatus for simultaneously pulling multiple crystals and an artificial crystal preparation device including the crystal cooling apparatus.

### Background Art

The photovoltaic industry is becoming a "new favor" of new energy industry, driven by the national macro-strategy policy of " peak carbon dioxide emissions and carbon neutrality ".

In this context, with the development of the photovoltaic industry, the global demand for polycrystalline silicon/single crystal silicon is growing rapidly, and the market supply falls short of demand. Due to this influence, the price of polycrystalline silicon/single crystal silicon, which is the main raw material of solar cell, is rapidly rising. Many domestic enterprises are expanding production.

Taking the polycrystalline silicon/single crystal silicon as an example, the amount of silicon core used in the whole production process of polycrystalline silicon/single crystal silicon is very large. Existing silicon cores are mostly prepared by means of zone melting (the pulling process is mainly completed by high-frequency coil and seed chuck). Its working principle is as follows. When working, by introducing a high-frequency current into the high-frequency coil and performing high-frequency induction heating, the high-frequency coil generates a current to cause a magnetic field line on the raw material rod. A melting zone is formed at the upper end of the heated raw material rod, and then the seed crystal is inserted into the melting zone. When the tip of the seed crystal is integrated with the melting region of the raw material rod, the seed crystal is slowly lifted, and the melted raw material melt will follow the rising of the seed crystal to form a new columnar crystal. The new columnar crystal is a finished silicon core.

In the actual production process of polycrystalline silicon /single crystal silicon production enterprises, it is found that it is very complicated to deal with the remaining materials in the preparation process of silicon core, the silicon core which is accidentally broken, and the crushed materials generated in the reduction, cutting, grinding, polishing and other process stages. Many enterprises directly discard the above-mentioned remaining materials, broken cores, crushed materials or stockpile them in a warehouse for the purpose of saving trouble. Still other companies recycle the rushed materials, pull them through a Czochralski furnace to form silicon rods, and then pull the silicon rods into a silicon core. This not only increases the cost of pulling the silicon core, but also results in a large waste of resources, etc. There are also some enterprises recycling the above-mentioned crushed materials, pulling the crushed materials into silicon rods through the Czochralski furnace, and then cutting the silicon rods into multiple columnar silicon rods with the size of 8 mm * 8 mm or 10 mm * 10 mm by a multi-wire cutting machine, which not only increases the production cost of the columnar silicon rods, but also may introduce more impurities during the cutting process. As a result, it reduces the product quality and also causes a large waste of resources, etc. Then, how to reuse the crushed silicon material becomes one of the long-term technical demands of a person skilled in the art.

The technology for pulling silicon rods from the Czochralski method is well established, and has been widely used in the preparation of artificial crystals. However, when the silicon rod is pulled by the conventional Czochralski method, only one silicon rod may be pulled in the center of the crucible, for example, the technique disclosed in Chinese utility model with Patent Number 201320678696.4, filed on October 30, 2013, the title of a soft shaft pulling type single crystal furnace, and Publication Number CN203639604U; and the technology disclosed in the Chinese invention patent with the Patent Number 202011063763.2, filed on September 30, 2020, Publication Number CN112176400 A, and the title of a Czochralski method single crystal furnace and a method for controlling temperature gradient of a melt thereof. The technical solutions disclosed in the above-mentioned two patents are all technical solutions for preparing a silicon rod by the Czochralski method. However, the above-mentioned two technical solutions can only achieve the simultaneous pulling of one silicon rod, and cannot achieve the simultaneous pulling of multiple silicon rods.

In addition, the inventors found by search a Chinese Invention Patent with the Patent Number 200910064106.7, filed on January 20, 2009, and the title of a silicon core pulled by the crushed material of crystals and an apparatus for implementing the method. An apparatus and method for pulling a silicon core using crushed materials of crystals is disclosed in the patent. Although the patent states that the silicon core can be pulled from crushed silicon materials, the pulled silicon core has a slow cooling rate, resulting in a slightly larger ellipticity of the silicon core and a low pulling efficiency. Accordingly, it would be a long felt technical need for those skilled in the art to provide a crystal cooling apparatus for an artificial crystal furnace that is capable of having a relatively fast cooling rate.

### Summary of the Invention

In order to solve the above problems, the present application provides a crystal cooling apparatus for simultaneously pulling multiple crystals, which is capable of cooling the pulled crystals relatively quickly and simultaneously pulling multiple crystals, thereby increasing the silicon core pulling speed. Moreover, the crystal cooling apparatus according to the present application can simultaneously pull multiple silicon cores by the crushed silicon material, effectively avoiding waste of resources of the crushed silicon material.

According to an aspect of the present application, the present application provides a crystal cooling apparatus for simultaneously pulling multiple crystals. The crystal cooling apparatus is provided with multiple first lift holes for pulled crystals to pass through and a cooling medium channel for cooling the crystals.

Preferably, the crystal cooling apparatus comprises an upper flange and a lower flange, and a crystal cooling pipe disposed between the upper flange and the lower flange; one end of the crystal cooling pipe is connected to the upper flange, the other end of the crystal cooling pipe being connected to the lower flange; the crystal cooling pipe forms the first lift hole; and the cooling medium channel is disposed at the periphery of the crystal cooling pipe.

Preferably, a water outlet and a water inlet for access of a cooling medium for cooling the crystals are disposed on the upper flange or the lower flange.

Preferably, the upper flange is provided with a crystal upper through hole penetrating through the upper flange, the crystal upper through hole being provided corresponding to the first lift hole.

Preferably, an upwardly-recessed groove is disposed at a lower surface of the upper flange, or a downwardly-recessed groove is disposed at an upper surface of the upper flange; a lower cover plate is disposed at an open end of the groove; the lower cover plate and the groove form a water inlet chamber; the crystal upper through hole penetrating through the upper flange is disposed at a groove bottom of the groove; and the crystal upper through hole is disposed corresponding to the first lift hole; and multiple through holes are disposed on the lower cover plate.

Preferably, upper and lower grooves are respectively disposed at the upper and lower surfaces of the upper flange; a cover plate of the water inlet chamber and a cover plate of a water return chamber are respectively disposed at the open ends of the upper and lower grooves; the cover plate of the water inlet chamber and the upper groove form a water inlet chamber; the cover plate of the water return chamber and the lower groove form a water return chamber; a crystal upper through hole penetrating to the groove bottom of the lower groove, a water outlet and a water inlet are respectively disposed on the cover plate of the water inlet chamber ; the crystal upper through hole is disposed corresponding to the first lift hole; the groove bottom of the upper groove is provided with a water inlet hole penetrating to the groove bottom of the lower groove; the water inlet chamber communicates with the water inlet; the water return chamber communicates with the water outlet; and multiple through holes are disposed on the cover plate of the water return chamber.

Preferably, the upper flange comprises an upper disc, a middle disc and a lower disc which are stacked to form a flange body; a middle hole penetrating through the flange body is disposed at the middle of the upper surface of the flange body; a hollow water return chamber is disposed at an upper portion of the flange body; a hollow water inlet chamber is disposed at a lower portion of the flange body; a connecting pipe penetrating to the water inlet chamber is disposed on the upper surface of the flange body, the connecting pipe forming a water inlet; a water outlet penetrating to the water return chamber is disposed on the upper surface of the flange body; a water return transition pipe penetrating to the water return chamber is disposed on the lower surface of the flange body; an crystal upper through hole penetrating through the flange plate is disposed at the upper surface of the flange plate at the periphery of the middle hole; and the crystal upper through hole is arranged corresponding to the first lift hole.

Preferably, a transition ring is disposed at the lower surface of the flange body; a middle hole is disposed at the middle of the transition ring; and a crystal upper through hole, a water outlet opening and a water return opening are disposed at the upper surface of the transition ring, respectively.

Preferably, the lower flange is provided with a crystal lower through hole penetrating through the lower flange; and the crystal lower through hole is disposed corresponding to the first lift hole.

Preferably, a downwardly-recessed groove is disposed at the upper surface of the lower flange; an upper cover plate is disposed at an open end of the groove; the groove and the upper cover plate form a water collection chamber; a crystal lower through hole penetrating to below the lower flange is disposed at a groove bottom of the groove; the crystal lower through hole is disposed corresponding to the first lift hole; and multiple through holes are disposed on the upper cover plate.

Preferably, a cooling disk is disposed below the lower flange; a cavity is disposed in the cooling disk; and the cooling disk are provided with crystal lift holes disposed corresponding to the crystal lower through holes and a water outlet hole and a water inlet hole respectively communicating with the cavity.

Preferably, a connection cylinder is disposed between the upper flange and the lower flange; the crystal cooling pipe is disposed inside the connection cylinder; one end of the crystal cooling pipe is connected to a crystal upper through hole disposed on the upper flange, the other end of the crystal cooling pipe being connected to a crystal lower through hole disposed on the lower flange; and the cooling medium channel is formed by a cavity among an inner edge surface of the connection cylinder, the lower end surface of the upper flange and the upper end surface of the lower flange.

Preferably, a bushing is sleeved at the periphery of the crystal cooling pipe; one end of the bushing communicates with a water inlet chamber disposed in the upper flange, the other end of the bushing being in communication with a water collection chamber disposed in the lower flange; the cooling medium channel is formed by the cooling chamber between the inner edge surface of the bushing and the outer edge surface of the crystal cooling pipe, the water inlet chamber and the water collection chamber.

Preferably, a bushing is sleeved on the periphery of the crystal cooling pipe; a downwardly-recessed semicircular step is disposed on an upper end of the bushing, and the upper end of the bushing communicates with a water inlet chamber disposed on the upper flange; an upper end of the semicircular step communicates with a water return chamber disposed at a lower part of the upper flange; a lower end of the bushing communicates with a water collection chamber disposed at the upper part of the lower flange or connects the lower flange; the cooling medium channel is formed by the cooling chamber between the inner edge surface of the bushing and the outer edge surface of the crystal cooling pipe, the water inlet chamber, the water return chamber and the water collection chamber.

Preferably, a separator is disposed in the cooling chamber between the crystal cooling pipe and the bushing.

Preferably, the crystal cooling apparatus is provided with multiple crystal cooling pipes; one of the crystal cooling pipe is disposed in the middle of the crystal cooling apparatus, and multiple groups of crystal cooling pipes are radially disposed at the periphery of the crystal cooling pipe in the middle, each group of crystal cooling pipes comprising at least two crystal cooling pipes; or a middle hole is disposed in the middle of the crystal cooling apparatus, and multiple groups of crystal cooling pipes are radially disposed on the periphery of the middle hole, each group of crystal cooling pipes comprising at least two of the crystal cooling pipes.

Preferably, a connection cylinder and an inner connection cylinder are respectively provided between the flange body and the lower flange; the crystal cooling pipe is disposed in a cavity between the connection cylinder and the inner connection cylinder; an upper end of the crystal cooling pipe is connected to the crystal upper through hole disposed on the flange body, and a lower end of the crystal cooling pipe is connected to the crystal lower through hole disposed on the lower flange; and the cooling medium channel is formed by a cavity among an inner edge surface of the connection cylinder and a lower end surface of the upper flange, an upper end surface of the lower flange, and an outer edge surface of the inner connection cylinder.

Preferably, a water outlet and a water inlet for access of a cooling medium for cooling the crystals are disposed on the connection cylinder.

Preferably, a cooling disk is disposed below the lower flange; a cavity is disposed in the cooling disk; the cooling disk is provided with the crystal lift hole disposed corresponding to the crystal lower through hole and the water outlet hole and water inlet hole respectively communicating with the cavity; the water inlet hole is connected to a lower end of a water inlet pipe; an upper end of the water inlet pipe passes through the lower flange and is connected to a water outlet below the flange body; the water outlet hole is connected to a lower end of a water outlet pipe; and an upper end of the water outlet pipe passes through the lower flange and communicates with the cooling medium channel on the flange body.

Preferably, the crystal cooling apparatus further comprises a thermal insulation plate disposed below the lower flange; and the thermal insulation plate is provided with at least one second lift hole disposed in one-to-one correspondence with the crystal lower through hole of the lower flange.

Preferably, the crystal cooling apparatus further comprises a thermal insulation plate disposed below the cooling disk; the thermal insulation plate is provided with at least one second lift hole; and the second lift hole is disposed in one-to-one correspondence with the crystal lift hole of the cooling disk.

Preferably, a central hole is formed at the middle of the thermal insulation plate; and the second lift holes are radially formed at a periphery of the central hole.

Preferably, an outline dimension of the thermal insulation plate is greater than or equal to an outline dimension of the lower flange or the cooling disk.

Preferably, an upwardly-raised step is disposed from the outside to the inside on the upper surface of the thermal insulation plate, the step corresponding to the stepped surface of the lower surface of the lower flange or the lower surface of the cooling disk.

Preferably, the thermal insulation plate is a barrel-type structure formed by providing a downwardly-recessed groove in the middle; and an inner edge surface of the groove is in clearance fit or interference fit with an outer edge surface of the lower flange or the cooling disk.

Preferably, a thermal insulation filler is disposed at the gap when the inner edge surface of the groove is in clearance fit with the outer edge surface of the lower flange or the cooling disk. Preferably, the cooling disk is provided with an upper through hole at the middle thereof; a cavity is disposed in the cooling disk; and the multiple crystal lift holes are radially disposed at a periphery of the upper through hole.

Preferably, a lower surface of the lower flange or the cooling disk is provided with a stepped surface formed by providing an upwardly-recessed step from the outside to the inside; and a circle of the crystal lift holes are disposed on each stepped surface.

According to another aspect of the present application, the present application provides an artificial crystal preparation device comprising the crystal cooling apparatus described above.

According to the present application, by providing multiple crystal cooling pipes between the upper flange and the lower flange, and providing the cooling medium channel at the periphery of the crystal cooling pipes, it is possible to use the cooling medium to form a low temperature region in the space above the crucible, thereby forming a temperature gradient that the lower part has an upper temperature and the upper part has a lower temperature, thus reducing the temperature of the molten silicon liquid above the crucible, increasing the viscosity of the silicon liquid, and facilitating the silicon liquid to follow the seed crystal for crystallization. Most importantly, the silicon core may be cooled to increase the pulling speed of the silicon core. According to the present application, simultaneous pulling of multiple silicon cores, etc. is achieved while increasing the silicon core pulling speed. In the apparatus for simultaneously pulling multiple silicon cores from crushed silicon material of the present application, waste of resources of the crushed silicon material is effectively avoided.

In addition, according to the present application, a thermal insulation plate is disposed below, for example, the lower flange or the cooling disk, and the surface of the crystal cooling mechanism is insulated by the thermal insulation plate, so that volatile adhering to the lower surface and the side wall of the crystal cooling mechanism due to condensation phenomenon is effectively avoided. In the present application, while avoiding the adhesion of volatiles on the crystal cooling mechanism, due to the heat preservation function of the thermal insulation plate, the cooling of the corresponding crucible region due to the low temperature below the crystal cooling mechanism is avoided, and the crystal cooling mechanism is prevented from carrying away excessive temperature, which has the effect of reducing heating energy consumption, etc. Meanwhile, due to the heat preservation function of the thermal insulation plate, the cooling effect of the cooling medium in the crystal cooling mechanism completely acts on the inner hole wall of the crystal lift hole, thereby improving the cooling effect on the pulled crystal, realizing the rapid crystallization of the crystal, serving the purpose of improving the crystal pulling speed, etc.

### Brief Description of the Drawings

Fig. 1 is a perspective view of a cooling apparatus according to a first embodiment of the present application;
Fig. 2 is a schematic partial perspective view of the cooling apparatus according to the first embodiment of the present application;
Fig. 3 is a schematic view of a structure of an upper flange of the cooling apparatus according to the first embodiment of the present application;
Fig. 4 is a schematic view of a structure of a lower flange of the cooling apparatus according to the first embodiment of the present application;
Fig. 5 is a schematic view showing a second structure of the cooling medium channel of the cooling apparatus according to the first embodiment of the present application;
Fig. 6 is a schematic view showing a third structure of the cooling medium channel of the cooling apparatus according to the first embodiment of the present application;
Fig. 7 is a schematic view of a fourth structure of the cooling medium channel of the cooling apparatus according to the first embodiment of the present application;
Fig. 8 is a schematic view of a structure of a bushing according to the first embodiment of the present application;
Fig. 9 is a schematic view of a first structure in which a cooling disk is connected to a cooling apparatus according to the first embodiment of the present application;
Fig. 10 is a schematic view of a second structure in which the cooling disk is connected to the cooling apparatus according to the first embodiment of the present application;
Fig. 11 is a schematic view of a third structure in which the cooling disk is connected to the cooling apparatus according to the first embodiment of the present application;
Fig. 12 is a schematic view of a structure of a separator according to the first embodiment of the present application;
Fig. 13 is a schematic view showing a fourth structure in which the cooling disk is connected to the cooling apparatus according to the first embodiment of the present application;
Fig. 14 is a detailed perspective view of the cooling disk shown in Fig. 13;
Fig. 15 is a schematic perspective view of the cooling apparatus provided with a thermal insulation plate according to a second embodiment of the present application;
Fig. 16 is a schematic partial perspective view of the cooling apparatus provided with the thermal insulation plate according to the second embodiment of the present application;
Fig. 17 is a schematic view of a structure of the upper flange of the apparatus according to the second embodiment of the present application;
Fig. 18 is a schematic view of a structure of the lower flange of the apparatus according to the second embodiment of the present application;
Fig. 19 is a schematic view showing a first alternative structure of the thermal insulation plate according to the second embodiment of the present application;
Fig. 20 is a schematic view showing a second alternative structure of the thermal insulation plate according to the first embodiment of the present application;
Fig. 21 is a schematic view showing a third alternative structure of the thermal insulation plate according to the first embodiment of the present application;
Fig. 22 is a schematic view showing a fourth alternative structure of the thermal insulation plate according to the first embodiment of the present application;
Fig. 23 is a schematic diagram of a specific application according to the first embodiment and the second embodiment of the present application;
Fig. 24 is a schematic view showing a fifth alternative structure of the thermal insulation plate according to the second embodiment of the present application;
Fig. 25 is a schematic view of a structure of a step on the thermal insulation plate according to the second embodiment of the present application;
Fig. 26 is a schematic view showing an alternative structure of Fig. 7.

### Detailed Description of the Invention

The present application is described in detail below by way of examples, without implying that there are any disadvantageous limitations to the present application. While the present application has been described in detail and specific embodiments thereof have been disclosed, it will be apparent to those skilled in the art that various changes and modifications can be made in the specific embodiments of the present application without departing from the spirit and scope of the application.

In the description of the present invention, it should be understood that the directional or positional relationships indicated by the terms "center", " lateral ", "length", "width", "height", "up", "down", "before", "back", "left", "right" and "vertical", "level", "top", "bottom", "inside", "outside", "side" and the like are based on the directional or positional relationships shown in the drawings. It is merely for the purpose of describing the present application and simplifying the description, and is not intended to indicate or imply that a particular orientation, configuration and operation of the referenced device or element is required and should not be construed as limiting the scope of the present invention.

In describing the present invention, it further needs to be noted that unless otherwise expressly specified and limited, the terms "provided", "mounted" "connected", and "connecting" should be interpreted broadly. For example, it can be a fixed connection or a detachable connection, or an integrated connection; it can be a mechanical connection, or an electrical connection; it can be directly connected or indirectly connected through an intermediate medium, and it can be the communication within two elements. For persons skilled in the art, the specific meaning of the above-mentioned terms in the present invention can be understood according to specific situations.

The present application provides a crystal cooling apparatus for simultaneously pulling multiple crystals. The crystal cooling apparatus is provided with multiple first lift holes for pulled crystals to pass through and a cooling medium channel for cooling the crystals.

The crystal cooling apparatus according to the present application can cool the pulled crystal faster and simultaneously pull multiple crystals, increasing the silicon core pulling speed.

Hereinafter, specific structures of preferred embodiments of the present application will be described in detail with reference to the accompanying drawings and embodiments.

### First embodiment

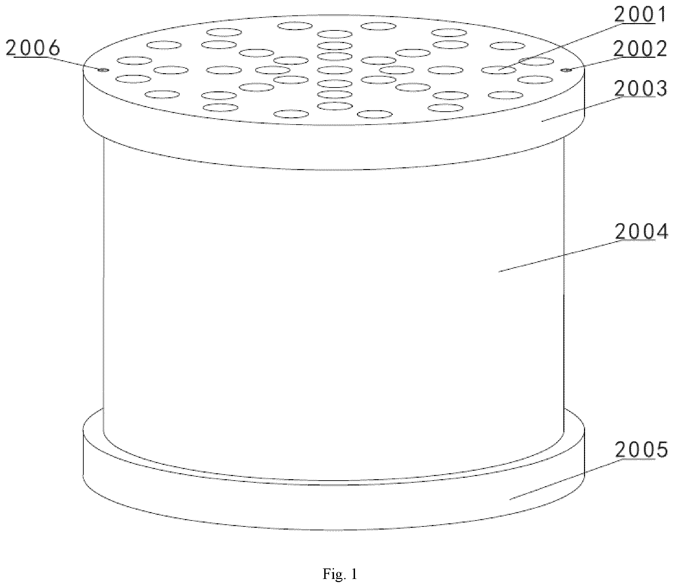

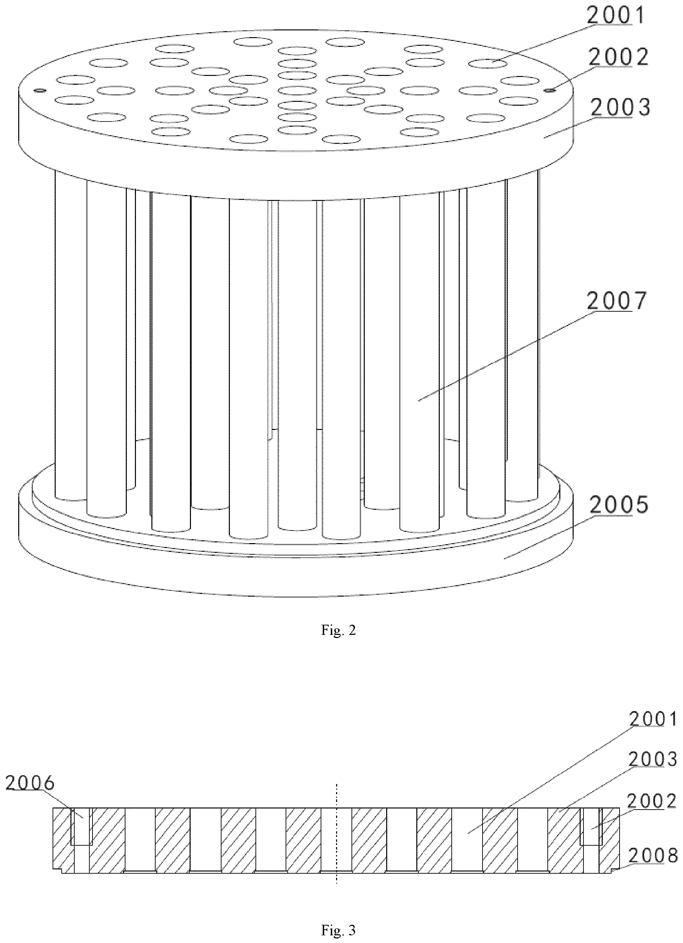

Figs. 1 to 14 show a crystal cooling apparatus for an artificial crystal furnace, which is one specific example of the crystal pulling mechanism of the present application. The crystal cooling apparatus includes an upper flange 2003, a lower flange 2005, a crystal cooling pipe 2007, and a cooling medium channel. The upper flange 2003 is connected to a lift mechanism of the crystal cooling apparatus. Multiple crystal cooling pipes 2007 for cooling crystals are disposed between the upper flange 2003 and the lower flange 2005. A first lift hole through which a crystal rod passes is formed in the crystal cooling pipe 2007. In practice, the arrangement form of multiple crystal cooling pipes 2007 is that one crystal cooling pipe 2007 is disposed in the middle, and then multiple groups of crystal cooling pipes 2007 are disposed radially at the periphery of the middle crystal cooling pipe 2007. Each group of crystal cooling pipes 2007 includes at least two crystal cooling pipes 2007. In practice, the arrangement form of the plurality of groups of crystal cooling pipes 2007 may be that crystal cooling pipes 2007 located on a concentric circle form a group. It is also possible that crystal cooling pipes 2007 extending outwards along the same diameter form a group. The number of crystal cooling pipes 2007 provided is specifically selected according to the number of crystals to be pulled. A cooling medium channel is disposed at the periphery of the crystal cooling pipe 2007. A cooling medium for cooling is introduced into the cooling medium channel. An inlet of the cooling medium channel is connected to a cooling source via a pipeline. An outlet of the cooling medium channel is connected to a cooling medium recovery mechanism via a pipeline, thereby forming the crystal cooling apparatus for an artificial crystal furnace.

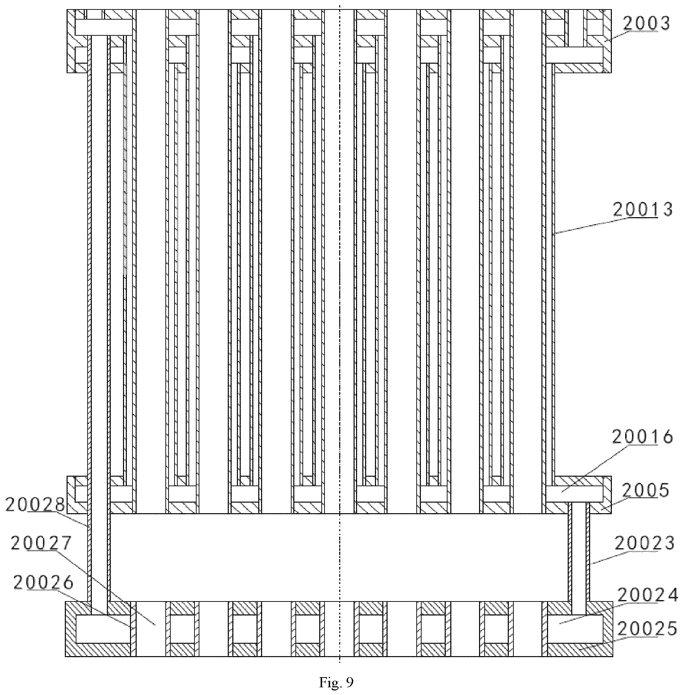

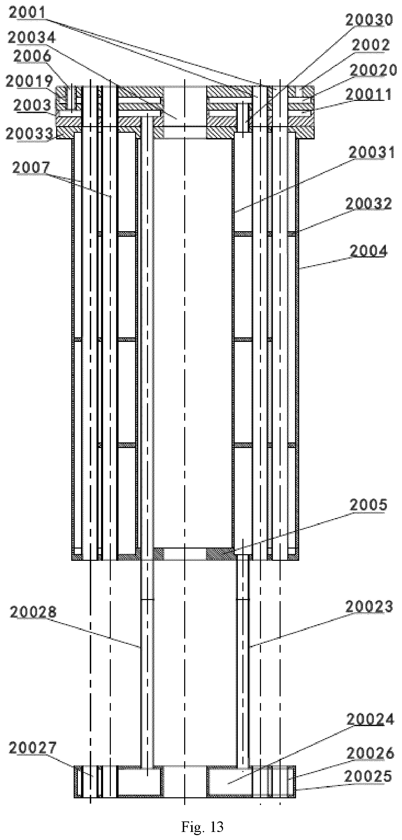

Further, as shown in Fig. 13, in the embodiment, it is also possible to use the connection cylinder 2004 and the inner connection cylinder 20031 to form a cooling medium channel in which the cooling pipe 2007 is placed to cool the whole structure. Specific protocols are described below. Further, as shown in Figs. 9 to 14, a cooling disk 20025 may be disposed below the lower flange 2005. A cavity 20024 is disposed in the interior of the cooling disc 20025. Multiple fixing columns 20026 are disposed in the cavity 20024. Crystal lift holes 20027 are respectively disposed on each fixing column 20026. The cavity 20024 communicates with a water outlet pipe 20023 and a water inlet pipe 20028 respectively. The water outlet pipe 20023 and the water inlet pipe 20028 communicate with the cooling medium channel.

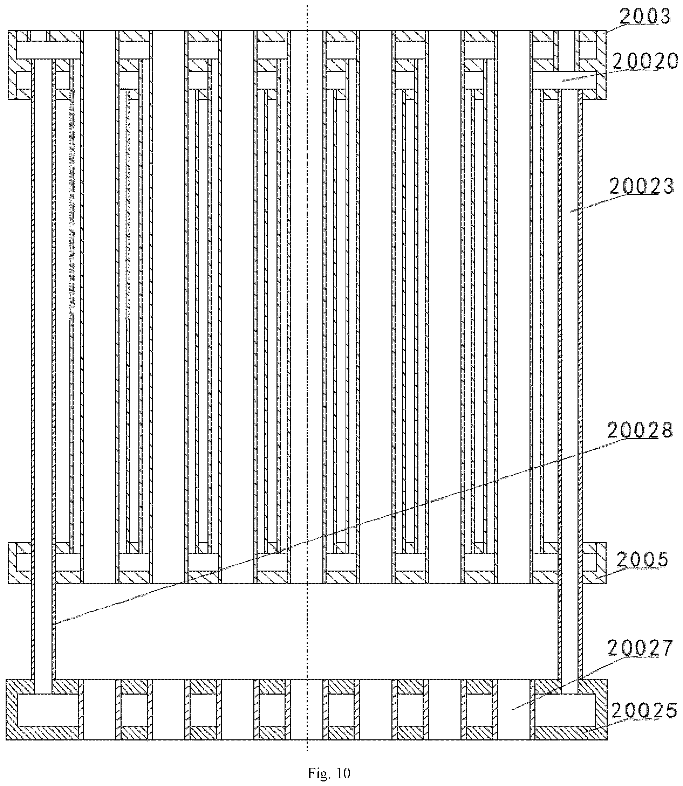

In practice, as shown in Fig. 9, the upper end of the water inlet pipe 20028 is connected to the water inlet chamber 20011 in the upper flange 2003. The upper end of the water outlet pipe 20023 is connected to the water collection chamber 20016 in the lower flange 2005. Alternatively, as shown in Fig. 10, the upper end of the inlet pipe 20028 is connected to the water inlet chamber 20011 in the upper flange 2003, and the upper end of the outlet pipe 20023 is connected to the water return chamber 20020 in the upper flange 2003.

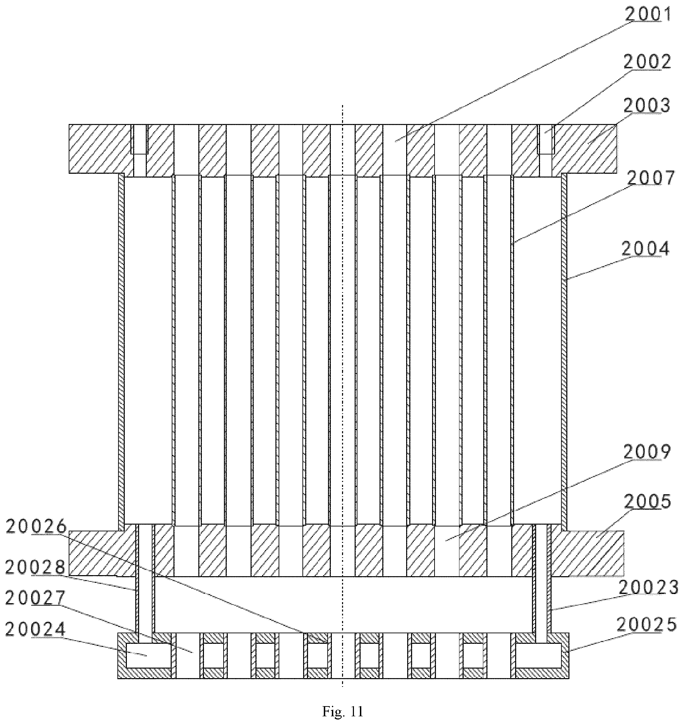

Alternatively, as shown in Fig. 11, a cooling disk 20025 is disposed below the lower flange 2005. A cavity 20024 is disposed in the interior of the cooling disk 20025. Multiple fixing columns 20026 are disposed in the cavity 20024. Crystal lift holes 20027 are respectively disposed on each fixing columns 20026. The cavity 20024 respectively communicates with a water outlet pipe 20023 and a water inlet pipe 20028. The water outlet pipe 20023 and the water inlet pipe 20028 respectively communicate through the lower flange 2005 to a cooling medium channel composed of the lower flange 2005, the connection cylinder 2004 and the upper flange 2003. Alternatively, the water outlet pipe 20023 and the water inlet pipe 20028 are communicated to a water inlet port and a water outlet port disposed on the lower flange 2005.

In practice, the upper ends of the water outlet pipe 20023 and the water inlet pipe 20028 may also pass through the lower flange 2005 and be directly connected to the water outlet 2002 and the water inlet 2006 disposed on the upper flange 2003, i.e., the cooling disk 20025 forms a separate cooling circuit. At this time, multiple water outlets 2002 and water inlets 2006 on the upper flange 2003 may be provided, i.e., the cooling disk 20025 and the crystal cooling pipe 2007 are cooled by the multiple water outlets 2002 and water inlets 2006, respectively.

Alternatively, the upper end of the water outlet pipe 20023 or the water inlet pipe 20028 is connected to the water outlet 2002 or the water inlet 2006. The upper end of the water inlet pipe 20028 or the water outlet pipe 20023 is connected to the cooling medium channel composed of the lower flange 2005, the connection cylinder 2004 and the upper flange 2003, i.e., realizing independent inletting and total discharging or realizing independent inletting and total discharging. That is, it may be flexibly set which member the outlet pipe 20023 and the inlet pipe 20028 are specifically connected to according to the structural form of the cooling medium channel.

In practice, a cooling disc 20025 is disposed below the lower flange 2005, and the inner hole of each crystal cooling pipe 2007 on the lower flange 2005 corresponds to and is arranged concentrically with each crystal lift hole 20027 on the cooling disc 20025. This ensures that the crystal rod passes smoothly through the crystal lift hole 20027 and the crystal cooling pipe 2007. Meanwhile, the operator may observe the crystal pulling situation through the gap between the lower flange 2005 and the cooling disk 20025.

In use, when the seed crystal brings the melt into the crystal lift hole 20027 on the cooling disk 20025, the seed crystal will start to crystallize to form a new crystal rod as the temperature decreases. As the crystal rod passes through crystal lift hole 20027 and enters crystal cooling pipe 2007, the crystal cooling pipe 2007 cools the crystal rod again to form the desired crystal rod. At this time, the operator may observe the pulling of the crystal rod through the gap between the lower flange 2005 and the cooling disk 20025. The crystal cooling pipe 2007 may not only cool the crystal rod (since the cooling medium in the cooling medium channel cools the crystal cooling pipe 2007, thereby forming a temperature gradient region required for crystal growth), but also can serve as a crystal rod guide to ensure that the lower end of the crystal rod does not shake (it needs to be explained that, when the crystal rod is pulled to a certain length, if a slight shaking occurs at the upper end and the shaking is transferred to the lower end of the crystal rod, the amplitude of the shaking increases by several times or more than ten times, thereby affecting the pulling of the crystal rod; and currently the pulling length of the crystal rod is generally about 2 m to 3 m).

As shown in Figs. 1 to 4, the first structure of the cooling medium channel arrangement is that a connection cylinder 2004 is disposed between the upper flange 2003 and the lower flange 2005. In practice, a lower annular positioning step 2008 may be disposed below the upper flange 2003. An upper annular positioning step 20010 may be disposed above the lower flange 2005. Then upper and lower ends of the connection cylinder 2004 may be sleeved on the lower annular positioning step 2008 and the upper annular positioning step 20010, respectively. The connection cylinder 2004 may be welded to the upper flange 2003 and the lower flange 2005 by welding. Multiple crystal cooling pipes 2007 are disposed within the connection cylinder 2004. The upper end of each crystal cooling pipe 2007 is connected to a crystal upper through hole 2001 disposed on the upper flange 2003, and the lower end of each crystal cooling pipe 2007 is connected to a crystal lower through hole 2009 disposed on the lower flange 2005, respectively. The cooling medium channel is formed by a cavity among the inner edge surface of the connection cylinder 2004, the lower end surface of the upper flange 2003 and the upper end surface of the lower flange 2005. A water outlet 2002 and a water inlet 2006 are respectively disposed on the upper flange 2003, and the water outlet 2002 and the water inlet 2006 respectively form an inlet and an outlet of the cooling medium channel.

According to a preferred embodiment of the present application, the structure of the upper flange 2003 is that the upper flange 2003 is a solid structure, and the upper flange 2003 is provided with a water outlet 2002, a water inlet 2006, and multiple crystal upper through holes 2001 penetrating from the upper surface to the lower surface.

According to another preferred embodiment of the present application, the structure of the lower flange 2005 is that the lower flange 2005 is a solid structure, and the lower flange 2005 is provided with multiple crystal lower through holes 2009 penetrating from the upper surface to the lower surface.

In use, the cooling medium enters by the water inlet 2006 the cooling medium channel formed by the upper flange 2003, the connection cylinder 2004 and the lower flange 2005. When the entire cooling medium channel is filled with the cooling medium, the cooling medium flows out from the water outlet 2002, thereby achieving the purpose of cooling the crystal rod in each crystal cooling pipe 2007.

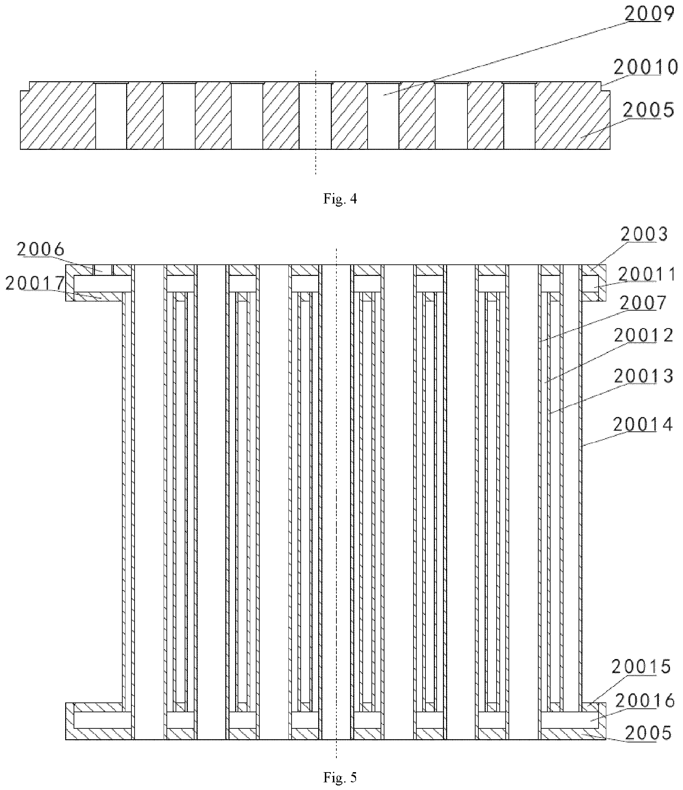

According to an embodiment of the present application, as shown in Fig. 5, the second structure of the cooling medium channel arrangement is that a bushing 20013 is respectively sleeved on the periphery of each crystal cooling pipe 2007. The upper end of each of the bushings 20013 communicates with the water inlet chamber 20011 disposed in the middle of the upper flange 2003, respectively. The lower end of each of the bushings 20013 communicates with the water collection chamber 20016 disposed in the middle of the lower flange 2005, respectively. A cooling medium channel is formed by the cooling chamber 20012 between the inner edge surface of the bushing 20013 and the outer edge surface of the crystal cooling pipe 2007, the water inlet chamber 20011 and the water collection chamber 20016. The water inlet chamber 20011 is connected to the water inlet 2006, and the water collection chamber 20016 is connected to the water outlet 2002 via the water return pipe 20014. The water outlet 2002 and the water inlet 2006 respectively form an inlet and an outlet of the cooling medium channel.

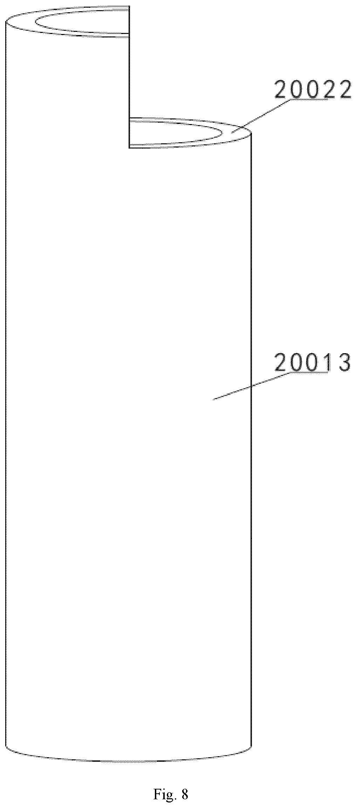

In practice, when the bushing 20013 is sleeved on the periphery of each crystal cooling pipe 2007 respectively, the cross-sectional shape of the bushing 20013 may be circular as shown in Fig. 8. Alternatively, the cross-sectional shape of the bushing 20013 may also be set as a complete circle surrounded by two semi-circles. Alternatively, the cross-sectional shape of the bushing 20013 may also be set as a complete circle surrounded by multiple arcs. Alternatively, the cross-sectional shape of the bushing 20013 may also be set to form a complete ellipse surrounded by two semi-ellipses. When the cross-sectional shape of the bushing 20013 is set as an ellipse, the two side walls of the short axis of the ellipse may be provided with a gap with the outer edge surface of the crystal cooling pipe 2007, or the two side walls of the short axis of the ellipse may not be provided with a gap with the outer edge surface of the crystal cooling pipe 2007, that is, the two side walls of the short axis of the ellipse fit with the outer edge surface of the crystal cooling pipe 2007. The two side walls of the long axis of the ellipse are provided with a gap with the outer edge surface of the crystal cooling pipe 2007, and a cooling medium channel is formed by the gap. When the cross-sectional shape of the bushing 20013 is set to be oval, the following two advantageous effects may be achieved.
1. When the bushings 20013 are arranged along the same circumference, since the short axis of the elliptical bushing 20013 is smaller than the diameter of the circular bushing 20013, it may be achieved that more bushings 20013 are arranged at the same circumference, so that the simultaneous pulling of more crystals may be achieved (when arranged, the long axis of the elliptical bushing 20013 faces towards the radial direction of the circumference).
2. When the oval-shaped bushing 20013 is provided, the technical effect of providing the separator 20029 between the circular-shaped bushing 20013 and the crystal cooling pipe 2007 may also be achieved after the elliptical bushing 20013 is sleeved on the crystal cooling pipe 2007 without providing the separator 20029.

In practice, the upper flange 2003 is constructed such that an upwardly-recessed groove is disposed on a lower surface of the upper flange 2003, or a downwardly-recessed groove is disposed on an upper surface of the upper flange 2003, and a lower cover plate 20017 is disposed at an open end of the groove. The cavity formed by the lower cover plate 20017 and the groove (namely, the cavity enclosed in the groove by the lower cover plate 20017) is a water inlet chamber 20011. Multiple crystal cooling pipe through holes penetrating to the upper surface of the upper flange 2003, a water outlet 2002 and a water inlet 2006 are respectively disposed at the groove bottom of the groove. Multiple bushing through holes and water return pipe through holes are disposed on the lower cover plate 20017.

The lower flange 2005 is constructed such that a downwardly-recessed groove is disposed on an upper surface of the lower flange 2005, an upper cover plate 20015 is disposed on an open end of the groove, and multiple crystal cooling pipe through holes penetrating to the lower surface of the lower flange 2005 are disposed on the groove bottom of the groove. Multiple bushing through holes are disposed in the upper cover plate 20015.

In use, the cooling medium enters the water inlet chamber 20011 in the upper flange 2003 via the water inlet 2006 and is then shunted into each cooling chamber 20012 via the water inlet chamber 20011. The cooling medium then flows through the cooling chamber 20012 and into the water collection chamber 20016 in the lower flange 2005. Finally, the cooling medium enters the water return pipe 20014 via the water collection chamber 20016 and then enters the water outlet 2002 via the water return pipe 20014.

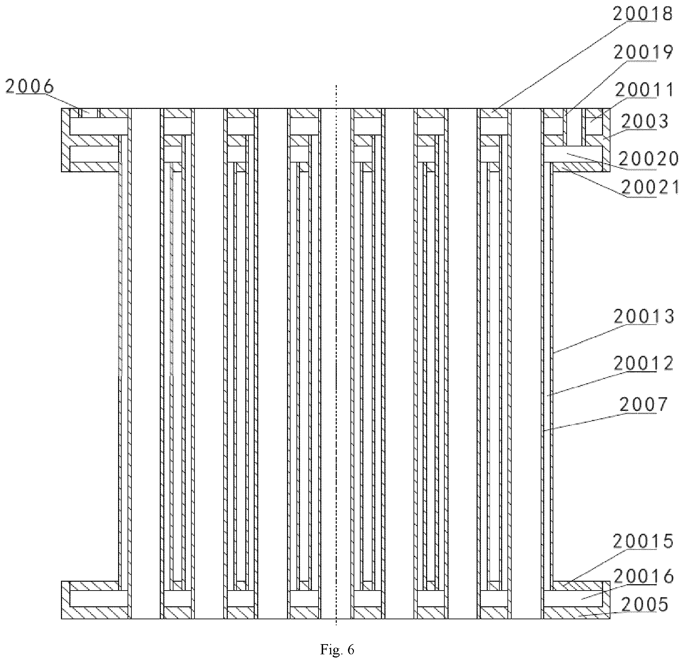

According to still another embodiment of the present application, as shown in Figs. 6 and 8, the third structure of the cooling medium channel arrangement is constructed such that a bushing 20013 is respectively sleeved at the periphery of each crystal cooling pipe 2007. The upper end of each of the bushings 20013 is respectively provided with a downwardly-recessed semicircular step 20022. The upper end of each of the bushings 20013 is respectively communicated with a water inlet chamber 20011 disposed at an upper portion of the upper flange 2003. The upper end of each of the semicircular steps 20022 is respectively communicated with a water return chamber 20020 disposed at a lower portion of the upper flange 2003. The lower end of each of the bushings 20013 is communicated with a water collection chamber 20016 disposed at an upper portion of the lower flange 2005, respectively. The cooling medium channel is formed by a cooling chamber 20012 between the inner edge surface of the bushing 20013 and the outer edge surface of the crystal cooling pipe 2007, a water inlet chamber 20011, a water return chamber 20020 and a water collection chamber 20016. The water inlet chamber 20011 is communicated with the water inlet 2006, and the water return chamber 20020 is connected to the water outlet 2002 via the connection pipe 20019. The water outlet 2002 and the water inlet 2006 respectively form an inlet and an outlet of the cooling medium channel.

In practice, the structure of the upper flange 2003 is that an upper groove and a lower groove are respectively disposed on the upper and lower surfaces of the upper flange 2003, and a cover plate 20018 for the water inlet chamber and a cover plate 20021 for the water return chamber are respectively disposed on the open ends of the upper groove and the lower groove. The cavity formed by the cover plate 20018 for the water inlet chamber and the upper groove is a water inlet chamber 20011, and the cavity formed by the cover plate 20021 for the water return chamber and the lower groove is a water return chamber 20020. Multiple crystal cooling pipe through holes, a water outlet 2002 and a water inlet 2006 penetrating to the bottom of the lower groove are respectively disposed on the cover plate 20018 for the water inlet chamber. Multiple bushing through holes and return pipe through holes are disposed on the cover plate 20021 for the water return chamber. The groove bottom of the upper groove is provided with a semicircular water inlet hole penetrating to the groove bottom of the lower groove. The water return chamber 20020 communicates with the water outlet 2002 through a connection pipe 20019. The structure of the lower flange 2005 is that a downwardly-recessed groove is disposed on the upper surface of the lower flange 2005, an upper cover plate 20015 is disposed on the open end of the groove, and multiple crystal cooling pipe through holes penetrating to the lower surface of the lower flange 2005 are disposed below the bottom of the groove. Multiple bushing through holes are disposed on the upper cover plate 20015.

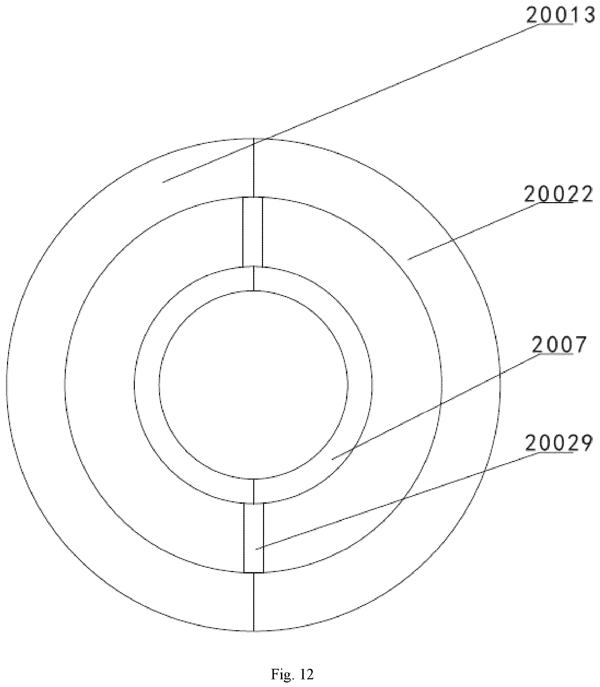

In practice, to enhance the cooling effect, a separator 20029 may be disposed in the cooling chamber 20012 between the crystal cooling pipe 2007 and the bushing 20013, as shown in Fig. 12. The cooling chamber 20012 is divided into a water inlet chamber body and a water outlet chamber body by the separator 20029, i.e., the cooling medium is guided to the lower end of the crystal cooling pipe 2007. In use, the cooling medium enters the water inlet chamber 20011 via the water inlet 2006, and then the cooling medium is shunted to the water inlet chamber in each cooling chamber 20012 via the water inlet chamber 20011. The cooling medium flows through the water inlet chamber body of the cooling chamber 20012, enters the water collection chamber 20016, then enters the water outlet chamber body of each cooling chamber 20012 via the water collection chamber 20016, and finally enters the water return chamber 20020 via the water outlet chamber body. The cooling medium in the water return chamber 20020 enters the water outlet 2002 via the connection pipe 20019.

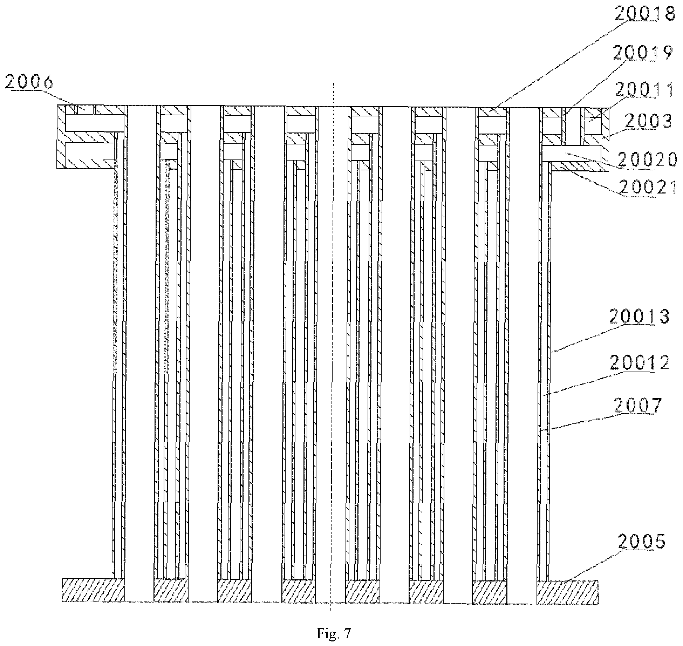

According to still another embodiment of the present application, as shown in Figs. 7 and 8, the fourth structure of the cooling medium channel arrangement is that a bushing 20013 is respectively sleeved at the periphery of each crystal cooling pipe 2007. A downwardly-recessed semicircular step 20022 is disposed at an upper end of each of the bushings 20013, respectively. The upper end of each of the bushings 20013 is communicated with a water inlet chamber 20011 disposed at an upper portion of the upper flange 2003, respectively. An upper end of each of the semicircular steps 20022 is communicated with a water return chamber 20020 disposed at a lower portion of the upper flange 2003, respectively. The lower end of each bushing 20013 is connected to the lower flange 2005, respectively. A cooling medium channel is formed by the cooling chamber 20012 between the inner edge surface of the bushing 20013 and the outer edge surface of the crystal cooling pipe 2007, the water inlet chamber 20011 and the water return chamber 20020. The water inlet chamber 20011 communicates with the water inlet 2006, the water return chamber 20020 communicates with the water outlet 2002 via the connection pipe 20019, and the water outlet 2002 and the water inlet 2006 respectively form an inlet and an outlet of the cooling medium channel.

As shown in Figs. 6, 7 and 9 and 10, the third structure of the upper flange 2003 is that an upper groove and a lower groove are respectively disposed on the upper and lower surfaces of the upper flange 2003, a cover plate 20018 for the inlet cavity and a cover plate 20021 for the return chamber are respectively disposed on the open ends of the upper groove and the lower groove, the cavity formed by the cover plate 20018 for the inlet cavity and the upper groove is the water inlet chamber 20011, and the cavity formed by the cover plate 20021 for the return chamber and the lower groove is the water return chamber 20020. Multiple crystal cooling pipe through holes penetrating to the bottom of the lower groove, a water outlet 2002 and a water inlet 2006 are respectively disposed on the cover plate 20018 for the water inlet chamber. Multiple sleeve through holes and return pipe through holes are disposed on the cover plate 20021 for the water return chamber. The groove bottom of the upper groove is provided with a semicircular water inlet hole penetrating to the groove bottom of the lower groove. The water return chamber 20020 communicates with the water outlet 2002 via a connection pipe 20019.

The structure of the lower flange 2005 is that the lower flange 2005 is a solid structure, and multiple crystal lower through holes 2009 penetrating to the lower surface of the lower flange 2005 are disposed on the upper surface of the lower flange 2005.

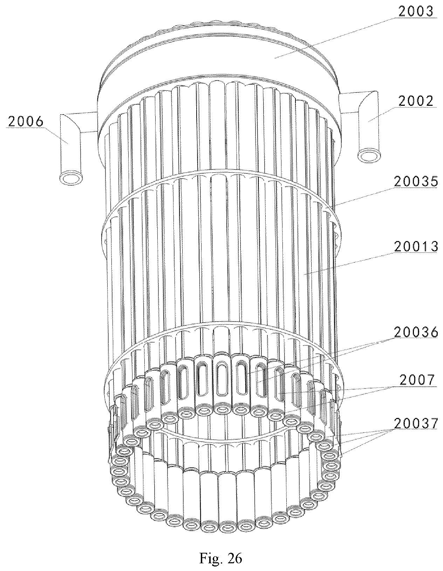

Alternatively, in practice, the lower flange 2005 shown in Fig. 7 may be replaced by a spout sealing ring 20037 of Fig. 26 to likewise achieve the object of the present invention.

As shown in Fig. 26, the structure of the upper flange 2003 is identical to that of the upper flange 2003 in Fig. 7, i.e., an upper groove and a lower groove are respectively disposed on the upper and lower surfaces of the upper flange 2003, and a cover plate 20018 for the water inlet chamber and a cover plate 20021 for the water return chamber are respectively disposed on the open ends of the upper groove and the lower groove. The cavity formed by the cover plate 20018 for the inlet cavity and the upper groove is a water inlet chamber 20011, and the cavity formed by the cover plate 20021 for the return chamber and the lower groove is a water return chamber 20020. Multiple crystal cooling pipe through holes penetrating to the bottom of the lower groove, a water outlet 2002 and a water inlet 2006 are respectively disposed on the cover plate 20018 of the water inlet chamber. Multiple bushing through holes and return pipe through holes are disposed on the cover plate 20021 for the water return chamber. The groove bottom of the upper groove is provided with a semicircular water inlet hole penetrating to the groove bottom of the lower groove. The water return chamber 20020 communicates with the water outlet 2002 via a connection pipe 20019. The upper end of the crystal cooling pipe 2007 passes through the cover plate 20021 for the water return chamber, the water return chamber 20020 and the water inlet chamber 20011 in sequence, and then communicates with the bushing through hole on the cover plate 20018 for the water inlet chamber. The bushing 20013 is sleeved on the outer edge surface of the crystal cooling pipe 2007, and a space is provided between the outer edge surface of the crystal cooling pipe 2007 and the inner edge surface of the bushing 20013. An independent cooling medium channel is formed by the cavity between the outer edge surface of the crystal cooling pipe 2007 and the inner edge surface of the bushing 20013. A spout sealing ring 20037 is disposed between the outer edge surface of the lower end of the crystal cooling pipe 2007 and the inner edge surface of the lower end of the sleeve pipe 20013 (the function of the spout sealing ring 20037 is equivalent to the function of the lower flange 2005 in Fig. 7).

In practice, the outer shape of the upper flange 2003 in Fig. 26 is provided as a ring-shaped structure, i.e., the middle part of the upper flange 2003 is provided with a central hole therethrough, and at least one circle of bushing through holes are disposed on the upper flange 2003. The bushing through holes are respectively connected to the crystal cooling pipe 2007. In practice, a bushing support ring 20035 may be disposed on the outer edge surface of the bushing 20013 to improve the stability of the bushing 20013. Further, it is also possible to provide a crystal observation hole 20036 at the lower end of an independent cooling medium channel, and observe the pulling of the crystal via the crystal observation hole 20036. In the implementation, the crystal observation hole 20036 should be provided to ensure the tightness of an independent cooling medium channel. For example, a blocking plate may be used to block the opening on the crystal cooling pipe 2007 and the bushing 20013, so that a sealed cavity body is formed by the cavity between the crystal cooling pipe 2007 and the bushing 20013.

In practice, to enhance the cooling effect, a separator 20029 may be disposed in the cooling chamber 20012 between the crystal cooling pipe 2007 and the bushing 20013, as shown in Fig. 12. The cooling chamber 20012 is divided into a water inlet chamber body and a water outlet chamber body by a separator 20029, and the lower ends of the water inlet chamber body and the water outlet chamber body communicate to form a circulating channel. In use, the cooling medium enters the water inlet chamber 20011 via the water inlet 2006 and is then shunted to the water inlet chamber body in each cooling chamber 20012 via the water inlet chamber 20011. The cooling medium flows through the water inlet chamber body of the cooling chamber 20012, enters the water outlet chamber body in the cooling chamber 20012, and then enters the water return chamber 20020 via the water outlet chamber body. The cooling medium in the water return chamber 20020 enters the water outlet 2002 via the connection pipe 20019.

In the practice of the present invention, the water inlet 2006 disposed on the upper flange 2003 may be disposed in one or more. When it is disposed in one and it is required to supply the cooling medium to the cooling disk 20025 and the cooling medium channel, respectively, the upper flange 2003 may be disposed in the structure as shown in Fig. 5, so that the cooling medium may be shunted to the cooling disk 20025 and the cooling medium channel via the water inlet chamber 20011.

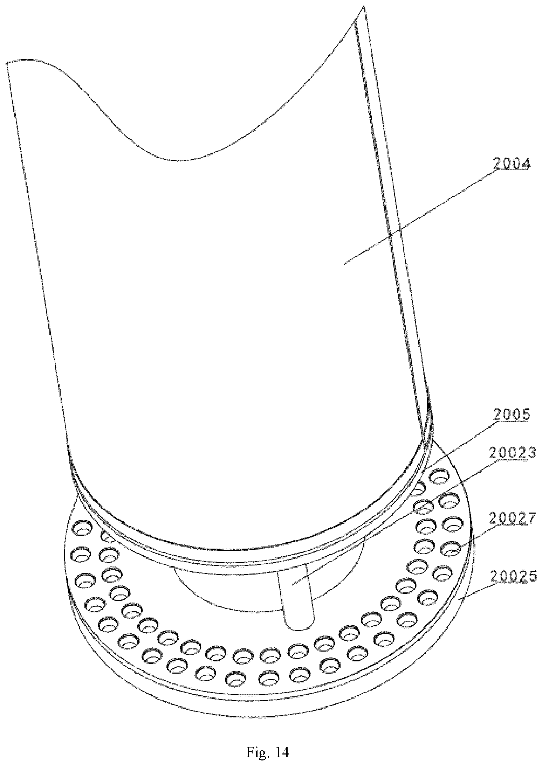

Further, preferably, as shown in Figs. 13 and 14, the upper flange 2003 includes, in practice, an upper disc, a middle disc and a lower disc. The upper disc, the middle disc and the lower disc are stacked to form a flange body. A central hole 20034 penetrating through the flange body is disposed at the upper central part of the flange body, a hollow water return chamber 20020 is disposed at the upper part of the flange body, and a hollow water inlet chamber 20011 is disposed at the lower part of the flange body. A connection pipe 20019 is disposed on the upper part of the flange body to pass through to the water inlet chamber 20011, and the connection pipe 20019 forms the water inlet 2006. A water outlet 2002 is disposed on the upper part of the flange body to pass through to the water return chamber 20020, and a water return transition pipe 20030 is disposed on the lower part of the flange body to pass through to the water return chamber 20020. A crystal upper through hole 2001 is disposed on the flange body at the periphery of the central hole 20034 to penetrate to the flange body, and the crystal upper through hole 2001 is arranged corresponding to the first lift hole. A water outlet is disposed below the flange body to pass through to the water inlet chamber 20011, the water outlet communicates with the water inlet of the cooling medium channel, and the water outlet of the cooling medium channel communicates with the water return transition pipe 20030.

Further, in practice, a transition ring 20033 may be disposed below the flange body, with a central hole 20034 in the middle of the transition ring 20033. The crystal upper through holes 2001, the water outlets and the water return ports are respectively provided above the transition ring 20033. In the implementation, the upper face of the transition ring 20033 may be connected to the flange body via a bolt. The lower face of the transition ring 20033 is fixedly connected to the connection cylinder 2004 and the inner connection cylinder 20031, so that the connection cylinder 2004 and the inner connection cylinder 20031 may be prevented from being directly connected to the flange body, and the flange body is movably connected to the connection cylinder 2004 and the inner connection cylinder 20031. When the flange body or the connection cylinder 2004 and the inner connection cylinder 20031 fail and need to be replaced, separate replacement or the like can be realized. In order to improve the sealing property of the cooling medium, sealing rings are respectively disposed at the water outlet and the water return port. In practice, the sealing ring may be disposed on the transition ring 20033 or on the flange body.

Further, in practice, a connection cylinder 2004 and an inner connection cylinder 20031 are disposed between the flange body and the lower flange 2005, respectively. A crystal cooling pipe 2007 is disposed in the cavity between the connection cylinder 2004 and the inner connection cylinder 20031. An upper end of the crystal cooling pipe 2007 is connected to the crystal upper through hole 2001 disposed on the flange body, and a lower end of the crystal cooling pipe 2007 is connected to the crystal lower through hole 2009 disposed on the lower flange 2005. The cooling medium channel is formed by a cavity among the inner edge surface of the connection cylinder 2004 and the lower end surface of the upper flange 2003, the upper end surface of the lower flange 2005, and the outer edge surface of the inner connection cylinder 20031. The water outlet 2002 and the water inlet 2006 respectively form an inlet and an outlet of the cooling medium channel. Further, in the implementation, in order to smooth the flow of the cooling medium in the cooling medium channel and achieve a better cooling effect, a deflector 20032 is disposed in the cooling medium channel. By the provision of the deflector 20032, the cooling medium may be forced to flow in a predetermined direction, thereby achieving a relatively uniform cooling effect.

Further, a cooling disk 20025 is disposed below the lower flange 2005. A cavity 20024 is disposed in the cooling disk 20025, and the cooling disk 20025 is provided with a crystal lift hole 20027 corresponding to the crystal lower through hole 2009, and a water outlet hole and a water inlet hole respectively communicating with the cavity 20024. The water inlet hole is connected to the lower end of the water inlet pipe 20028, and the upper end of the water inlet pipe 20028 passes through the lower flange 2005 and is connected to the water outlet below the flange body. The water outlet hole is connected to the lower end of the water outlet pipe 20023, and the upper end of the water outlet pipe 20023 passes through the lower flange 2005 to communicate with the cooling medium channel on the flange body.

In use, the cooling disk 20025 may or may not be disposed below the lower flange 2005. If the cooling disk 20025 is disposed below the lower flange 2005, the specific structure is as shown in Fig. 13. The cooling medium enters the water inlet chamber 20011 through the water inlet 2006, then enters the water inlet pipe 20028 via the water outlet on the water inlet chamber 20011, enters the cavity 20024 in the cooling disk 20025 via the water inlet pipe 20028, enters the water outlet pipe 20023 via the cavity 20024, enters the cooling medium channel via the water outlet pipe 20023, is guided in the cooling medium channel by the deflector 20032, enters the water return chamber 20020 by the water return transition pipe 20030 in the cooling medium channel, and enters the water outlet 2002 via the water return chamber 20020 and is discharged. When the cooling disk 20025 is not disposed below the lower flange 2005, the cooling medium enters the water inlet chamber 20011 via the water inlet 2006, and then enters the water inlet pipe 20028 via the water outlet on the water inlet chamber 20011. At this time, when the water inlet pipe 20028 is disposed inside the cooling medium channel, the lower end of the water inlet pipe 20028 is located at the lower part of the cooling medium channel. After the cooling medium flows into the lower part of the cooling medium channel via the water inlet pipe 20028, the cooling medium is guided in the cooling medium channel by the deflector 20032. The cooling medium flows from the lower part of the cooling medium channel to the upper part, and the cooling medium enters the water return chamber 20020 via the water return transition pipe 20030 in the upper part of the cooling medium channel, and enters the water outlet 2002 via the water return chamber 20020 and is discharged. When the water inlet pipe 20028 is disposed outside the cooling medium channel, the lower end of the water inlet pipe 20028 is located at the lower part of the cooling medium channel, and the lower end of the water inlet pipe 20028 is connected to the water inlet arranged at the lower part of the cooling medium channel via an elbow. After the cooling medium flows into the lower part of the cooling medium channel via the water inlet pipe 20028, the cooling medium is guided in the cooling medium channel by the deflector 20032. The cooling medium flows from the lower part of the cooling medium channel to the upper part, and the cooling medium enters the water return chamber 20020 via the water return transition pipe 20030 in the upper part of the cooling medium channel, and enters the water outlet 2002 via the water return chamber 20020 and is discharged. Alternatively, when the cooling disk 20025 is not disposed below the lower flange 2005, the cooling medium enters the water inlet chamber 20011 via the water inlet 2006, and then enters the water inlet pipe 20028 via the water outlet on the water inlet chamber 20011. At this time, the lower end of the water inlet pipe 20028 is located at the upper part of the inside of the cooling medium channel. After the cooling medium enters the cooling medium channel, the cooling medium is guided in the cooling medium channel to the bottom of the cooling medium channel via a deflector 20032. At this time, the water outlet pipe 20023 is connected to the lower part of the cooling medium channel. The lower end of the water outlet pipe 20023 is located at the lower part of the cooling medium channel. The upper end of the water outlet pipe 20023 is connected to the water return transition pipe 20030. The cooling medium at the bottom of the cooling medium channel enters the water return chamber 20020 via the water outlet pipe 20023 and the water return transition pipe 20030, and enters the water outlet 2002 via the water return chamber 20020 and is discharged.

In the practice of the present invention, all of the cooling medium inlets and outlets referred to may be disposed in multiple groups.

In a specific application, the crystal cooling apparatus according to the present embodiment is disposed above the crucible in the furnace chamber, and the lower surface of the lower flange 2005 or the lower surface of the cooling disk 20025 is close to but not in contact with the silicon melt in the crucible. In operation, the crushed silicon material is firstly put into the crucible. The heater is turned on to heat the crucible located on the crucible support seat. After the crushed silicon material in the crucible melts into a silicon material melt, the upper lifting head drives the seed crystal to descend. When the seed crystal passes through the crystal cooling pipe 2007 or the crystal cooling pipe 2007 and the crystal lift hole 20027, it is in contact with the silicon melt and stops the seed crystal from descending, and the seed crystal is slowly lifted up after the lower end of the seed crystal melts. At this time, since the cooling medium is introduced in the present invention, the temperature of the lower surface of the lower flange 2005 or the lower surface of the cooling disk 20025 forms a temperature gradient with the high temperature at the lower part and the low temperature at the upper part. At this time, the silicon melt rises along with the seed crystal, and as the silicon melt approaches the lower surface of the lower flange 2005 or the lower surface of the cooling disk 20025, the silicon melt gradually crystallizes since the temperature therein is lower than that of the crucible. When the crystallized silicon melt enters the crystal cooling pipe 2007 or the crystal cooling pipe 2007 and the crystal lift hole 20027, the temperature gradually decreases, thereby forming a desired silicon core. In use, the cooling medium channels of the present invention allow for forced cooling of the just-crystallized silicon core, improving the yield and pulling efficiency of the silicon core.

The crushed silicon materials involved in the present invention not only include the residual materials occurring during the preparation of the silicon core, the silicon core which is inadvertently broken, the crushed materials produced by the polycrystalline silicon/single crystal silicon production enterprise during the process stages of reduction, cutting, grinding and polishing, etc., but also include silicon materials of other shapes (such as cauliflower materials, silicon rods with a smaller length, etc.). Or, according to the present invention, the silicon core may be directly pulled using silicon materials which are directly purchased.

In practice, the invention may be used not only for the pulling of silicon cores, but also for the pulling of other crystalline materials.

According to this example, by providing multiple crystal cooling pipes between the upper flange and the lower flange, and providing the cooling medium channel at the periphery of the crystal cooling pipes, it is possible to use the cooling medium to form a low temperature region in the space above the crucible, thereby forming a temperature gradient with a higher temperature at the lower part and a lower temperature at the upper part, thus reducing the temperature of the molten silicon liquid above the crucible, increasing the viscosity of the silicon liquid, and facilitating the silicon liquid to follow the seed crystal for crystallization. Most importantly, the silicon core may be cooled to increase the pulling speed of the silicon core. According to this example, simultaneous pulling of multiple silicon cores, etc. is achieved while increasing the silicon core pulling speed. When the example is applied to an apparatus for simultaneously pulling multiple silicon cores from crushed silicon material, waste of resources of the crushed silicon material is effectively avoided., which is suitable for a wide range of popularization and application.

### Second embodiment

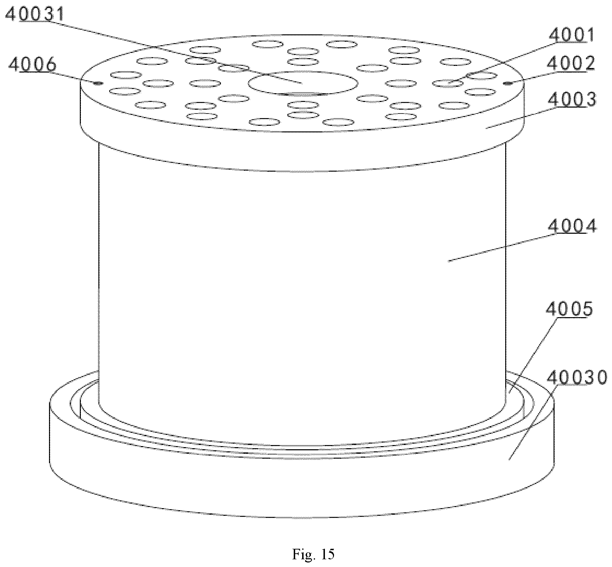

Figs. 15 to 21 show schematic views of a cooling apparatus provided with a thermal insulation plate according to the second embodiment of the present application, which combines the cooling apparatus according to the first embodiment with the thermal insulation plate. Specifically, the thermal insulation plate is disposed below the cooling apparatus.

The arrangement of the structures such as the cooling medium channel, the bushing, the cooling disk, and the separator in the present embodiment may adopt the structures in the first embodiment described above (for example, as shown in Figs. 5 to 14), and the structure of the thermal insulation plate in the present embodiment is shown in Figs. 15, 16, 19, 20, 21, and 22. However, the structures of the components in the present application are not limited thereto.

A crystal cooling apparatus for crystal pulling described in connection with Figs. 15 to 18 includes an upper flange 4003, a lower flange 4005, a crystal cooling pipe 4007, a cooling medium channel and a thermal insulation plate 40030, and multiple crystal cooling pipes 4007 are disposed between the upper flange 4003 and the lower flange 4005.

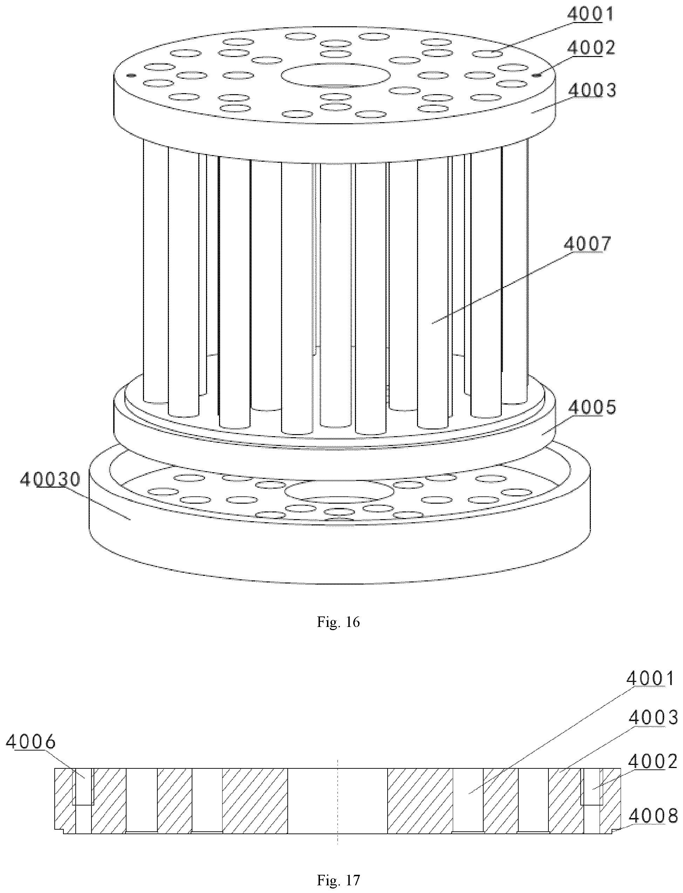

In practice, the arrangement form of multiple crystal cooling pipes is that one crystal cooling pipe is disposed in the middle, multiple groups of crystal cooling pipes are disposed radially at the periphery of the middle crystal cooling pipe, and each group of crystal cooling pipes includes at least two crystal cooling pipes. Alternatively, the second arrangement form of the multiple crystal cooling pipes is that multiple groups of crystal cooling pipes are radially disposed on the periphery of the gas through hole 40031 on the upper flange 4003 (as shown in Fig. 16), and the arrangement form of the multiple groups of crystal cooling pipes may be that crystal cooling pipes located on a concentric circle form one group. It is also possible to group the crystal cooling pipes outwardly extending along the same diameter. Each group of crystal cooling pipes includes at least two crystal cooling pipes, and the number of crystal cooling pipes 4007 arranged is specifically selected according to the number of crystals to be pulled.

A cooling medium channel is disposed at the periphery of the crystal cooling pipe 4007. A cooling medium for cooling is introduced into the cooling medium channel. An inlet of the cooling medium channel is connected to a cooling source via a pipeline. An outlet of the cooling medium channel is connected to a cooling medium recovery mechanism via a pipeline. A thermal insulation plate 40030 is disposed below the lower flange 4005.

Alternatively, as shown in Figs. 5-11, a cooling disc 20025 is disposed below the lower flange 2005. A cavity 20024 is disposed in the middle of the cooling disc 20025. Multiple fixing columns 20026 are disposed in the cavity 20024. Crystal lift holes 20027 are respectively disposed on each fixing column 20026. The cavity 20024 communicates with a water outlet pipe 20023 and a water inlet pipe 20028 respectively. The water outlet pipe 20023 and the water inlet pipe 20028 communicate with the cooling medium channel. A thermal insulation plate 40030 is disposed below the cooling disk 20025 to form the crystal cooling apparatus for crystal pulling.

In the practical application of the present invention, by providing a thermal insulation plate, the problem in practical application may be solved and the following effects can be achieved.
1. Since the cooling medium is introduced into the lower flange or cooling disk close to the melt in the crucible, the outer surface temperature of the lower flange or cooling disk is lower than the temperature of the region in which it is located. When the silicon material in the crucible is melted into a silicon liquid, impurities in the silicon liquid and in the furnace chamber volatilize and float to the lower bottom surface or side wall of the lower flange or cooling disk. Since the cooling medium is introduced into the lower flange or the cooling disk, the temperature of the lower flange or the cooling disk is relatively low, and then the volatile condenses and adheres to the bottom surface or the side wall of the lower flange or the cooling disk. When the volatiles accumulate to a certain thickness, they fall into the crucible and float on the upper surface of the melt due to the turbulence of the gas flow and the effect of thermal expansion and contraction. Since the melting point of the volatiles is higher than the melting point of the silicon material, the volatiles cannot be melted and cannot be vaporized. In other words, the volatiles will persist on the upper surface of the melt. Since the crucible rotates at all times during pulling, the volatiles in the crucible will not be stationary at a certain point on the upper surface of the silicon melt, but floating at a variable position. Once the floater is attached to the crystallization position of the silicon core, it causes the convex deformation of the outer edge surface of the pulled silicon core, and even causes the silicon core to be stuck in the crystal through hole due to the change of the diameter of the silicon core in severe cases. It is finally forced to stop and end the pulling of this round. The pulled silicon core may not be used as a finished product and can only be discarded.
   By the provision of the thermal insulation plate, it is possible to reduce or avoid that the cooling medium introduced causes the surface temperature of the lower flange or cooling disk to be lower than the temperature at which the volatiles adhere and deposit in the furnace, thereby reducing or avoiding that the volatiles in the melt condense and adhere to the outer surface of the lower flange or cooling disk.
2. Since the underside of the lower flange or cooling disk is planar, the cooling effect of the cooling medium on each crystal lift hole in the lower flange or cooling disk is the same. In actual use, a cylindrical heater is used to heat the outside of the crucible, which results in a higher temperature in the outer region than in the central region due to the circular crucible. The temperature in the crucible gradually decreases from the inner edge of the crucible to the center of the crucible. Thus, the crystals in the outer ring of the lower flange or the cooling disk at the time of pulling have a lower crystallization rate than the crystals in the inner ring of the lower flange or the cooling disk due to the temperature of the outer ring being higher than the temperature of the inner ring (faster the closer to the center of the crucible the crystals are, the faster the crystallization rate will be due to the relatively low temperature). The diameter of the crystals in the outer ring of the lower flange or the cooling disk will be smaller than the diameter of the crystals in the inner ring of the lower flange or the cooling disk under the condition of the same pulling rate, thereby resulting in inconsistent diameters of multiple crystals being pulled at the same time.
   The temperature uniformity of each crystal lower through hole 2009 or crystal lift hole 20027 on the lower flange 2005 or the cooling disc 20025 may be better ensured by the thermal insulation plate (namely, the temperature of the crystal lower through hole 2009 of the inner ring and the crystal lower through hole 2009 of the outer ring on the lower flange or the temperature of the crystal lift hole 20027 of the inner ring and the crystal lift hole 20027 of the outer ring on the cooling disc 20025 may be adjusted, thereby achieving that the temperature of the crystal lower through hole 2009 or crystal lift hole 20027 on the inner ring and the outer ring tends to be isothermal), thereby ensuring the consistency of crystal crystallization of the inner and outer rings.
3. The lower surface of the lower flange or the cooling disk is close to but not in contact with the upper surface of the melt in the crucible, and the low temperature of the surface of the lower flange or the cooling disk will absorb part of the heat above the crucible, thereby causing unnecessary heat loss and resulting in a certain loss of electricity consumption, etc.

By the provision of the thermal insulation plate, it is also possible to make the temperature of the crystallization region in the crucible tend to be uniform, reducing or avoiding the undesirable cooling down of the crystallization region in the crucible caused by the cooling medium in the lower flange 2005 or the cooling disk 20025 (the surface temperature of the lower flange 2005 or the cooling disk 20025 is low, and a part of the heat may be taken away; and the temperature decreases after the heat is lost). Furthermore, since it is ensured that the temperature of the crystallization region in the crucible does not decrease, it is not necessary to increase the heating power to ensure that the temperature of the crystallization region in the crucible is not decreased, thereby achieving the effect of reducing energy consumption (namely, through the arrangement of the thermal insulation plate, the absorption of the liquid surface temperature of the melt in the crucible by the lower flange 2005 or the cooling disk 20025 can be reduced or adjusted, thereby avoiding unnecessary heat loss and an increase in power consumption, etc.), and further achieving the uniform temperature of the crystallization region in the crucible, etc.

The thickness of the surface of the lower flange 4005 or the cooling disk 20025 may be increased by providing the thermal insulation plate. When the thickness of the surface of the lower flange 4005 or the cooling disk 20025 is increased, the cooling effect of the lower flange 4005 or the cooling disk 20025 is improved (in the present application, the wall thickness of the lower flange 4005 or the cooling disk 20025 is adjusted by providing the thermal insulation plate, and then the dissipation effect of the cooling air is improved, i.e., the cooling at the thin wall is fast, and the cooling at the thick wall is slow), thereby reducing the low-temperature dissipation too fast in the lower flange 4005 or the cooling disk 20025.

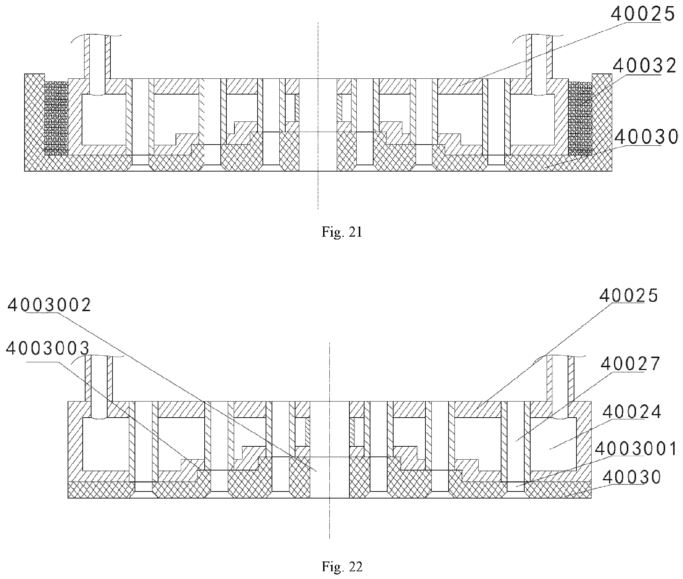

Further, as shown in Figs. 21 and 22, a stepped surface is formed by disposing at least one upwardly-recessed step from outwardly to inwardly below the lower flange or cooling disk 40025 of the cooling apparatus. In order to achieve the pulling of more crystal rods at the same time, multiple rings of crystal lift holes 40027 are disposed on the lower flange or the cooling disc 40025 at intervals from the outer edge to the inside (as shown in Fig. 22). At this time, in order to ensure the consistency of the diameter of the crystal pulled by each ring of crystal lift hole 40027, the technical problem mainly to be avoided is to overcome the problem of uneven temperature of the melt in the crucible. Therefore, a step surface is formed by disposing at least one upwardly-recessed step from the outside to the inside under the lower flange or the cooling disc 40025. A ring of crystal lift holes 40027 are respectively arranged on each step surface. The shape of the step surface corresponds to the step 4003003 on the thermal insulation plate 40030 (as shown in Figs. 21 or 22). When implemented, the step may better ensure the temperature uniformity of the crystal through hole or crystal lift hole 40027 on the lower flange 4005 or the cooling disc 40025, so as to ensure the consistency of crystal crystallization in the inner and outer rings.

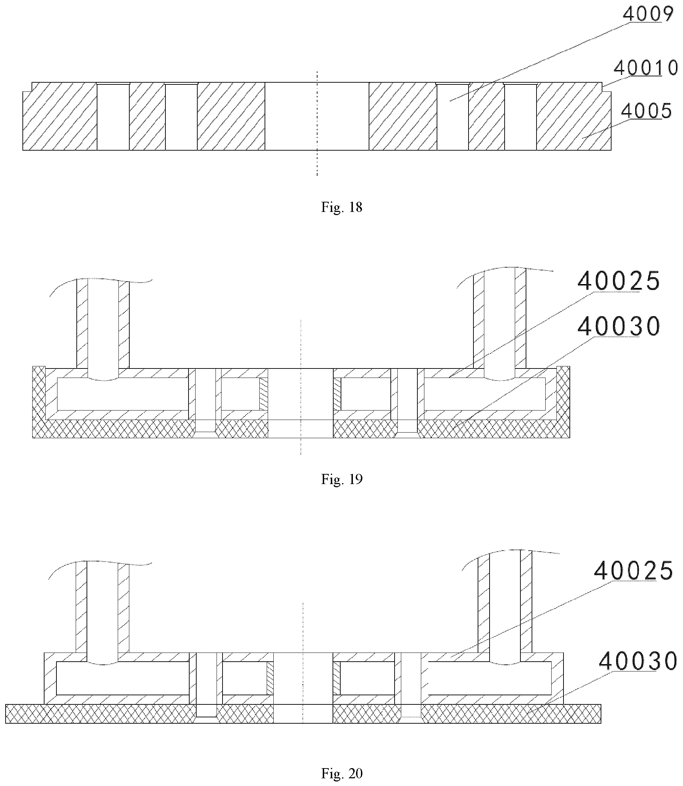

Further, as shown in Fig. 20, the thermal insulation plate 40030 may have a plate-type structure. Multiple through holes 4003001 are disposed on the thermal insulation plate 40030, and each through hole 4003001 corresponds to a crystal lower through hole 4009 on the lower flange 4005 or a crystal lift hole 40027 on the cooling disk 40025 (as shown in Fig. 20), respectively. The outline dimension of the thermal insulation plate 40030 is greater than or equal to the outline dimension of the lower flange 4005 or the cooling disk 40025. In practice, a central hole may be disposed in the middle of the thermal insulation plate 40030, such as 4003002 in Fig. 22. Multiple groups of through holes may be radially disposed on the periphery of the central hole, such as 4003001 in Fig. 22. The central hole and the through holes respectively correspond to the crystal lower through hole 2009 or the crystal lift hole 40027 on the lower flange or the cooling disk.

Further, as shown in Fig. 22, when the thermal insulation plate 40030 has a plate-type structure, at least one upwardly-raised step 4003003 is disposed on the upper surface of the thermal insulation plate from the outside to the inside, and the step 4003003 is matched with the step surface below the lower flange or the cooling apparatus or the cooling disk 400254.

Further, as shown in Figs. 15, 16 and 19 and 20, alternatively, the thermal insulation plate 40030 is provided with a downwardly-recessed groove in the middle of the thermal insulation plate to form a barrel-shaped structure. Multiple through holes are disposed on the thermal insulation plate. Each through hole corresponds to a crystal lower through hole 4009 on the lower flange or a crystal lift hole 40027 on the cooling disk 40025 (as shown in Fig. 22), respectively. The inner edge surface of the groove has a clearance fit or an interference fit with the outer edge surface of the lower flange 4005 or the cooling disk 40025.

Further, as shown in Fig. 15 and Fig. 16 and Figs. 19 and 21, the thermal insulation plate 40030 is provided with a downwardly-recessed groove in the middle thereof to form a barrel-type structure. In practice, an alternative configuration is to place an thermal insulation ring on top of the thermal insulation plate of the plate-type configuration, the combination of the thermal insulation ring and the thermal insulation plate of the plate-type configuration forming a barrel-type configuration.

In practice, the thermal insulation ring has a ring-shaped structure. One thermal insulation ring or multiple thermal insulation rings are stacked together and placed on the thermal insulation plate of the flat plate-shaped structure. That is, the thermal insulation plate of the barrel-type structure may be provided as an integral structure or may be provided as a split structure. When the thermal insulation plate of the barrel-type structure is provided as a split structure, it includes a thermal insulation ring and a bottom plate. The ring body of the thermal insulation ring is disposed on the bottom plate or multiple thermal insulation rings are stacked on the bottom plate. The ring body of the thermal insulation ring forms a barrel wall of the thermal insulation plate of the barrel structure, and the bottom plate forms a barrel bottom of the thermal insulation plate of the barrel structure.

Alternatively, multiple arc-shaped thermal insulation blocks are placed on the thermal insulation plate of the plate-type structure. The thermal insulation ring is surrounded by the multiple arc-shaped thermal insulation blocks. The thermal insulation ring surrounded by the multiple arc-shaped thermal insulation blocks and the thermal insulation plate of the plate-type structure are combined to form a barrel-type structure.

In practice, the thickness of each arc-shaped thermal insulation block and the spacing between two arc-shaped thermal insulation blocks may be adjusted by cutting a complete thermal insulation ring into multiple arc-shaped blocks to form arc-shaped thermal insulation blocks, and then recombining the cut arc-shaped blocks into a complete thermal insulation ring at a predetermined spacing.

In the implementation, the material of the thermal insulation plate of the plate-type structure and the thermal insulation ring may be set to be the same material. Alternatively, the materials of the thermal insulation plate of the plate-type structure and the thermal insulation ring may be set as different materials.

Further, as shown in Fig. 21, when the outer edge surface of the lower flange or cooling disk 40025 is in clearance-fit with the inner edge surface of the groove, a thermal insulation filler 40032 is disposed at the clearance. The thermal insulation filler is any one of a quartz felt or a graphite felt or a zirconium felt.

Further, as shown in Fig. 21, when the thermal insulation plate 40030 is disposed in a barrel-type structure, at least one upwardly-raised step is disposed from the outside to the inside on the upper side of the thermal insulation plate. As shown in Fig. 22 (4003003), the step is matched with the step surface below the lower flange 4005 or the cooling disk 40025. In the implementation, the step may better ensure the temperature uniformity of the crystal lower through hole 4009 on the lower flange 4005 or the crystal lift hole 40027 on the cooling disc 40025. Since the temperature distribution range of the crucible is that the peripheral temperature is higher than the central temperature, the cooling range of the lower flange 4005 or the cooling disc 40025 should also be changed during crystal pulling, so as to ensure the consistency of crystal crystallization in the inner and outer circles.

In practice, the outline dimensions of the thermal insulation plate are larger than the outline dimensions of the lower flange or cooling disk, and the structure is as shown in Fig. 20. The outer edge of the thermal insulation plate 40030 extends outwardly so as to reduce or avoid adhesion of volatiles to the outer edge of the lower flange 4005 or cooling disk 40025, while also acting as a tray for the volatiles to fall onto the upper surface of the thermal insulation plate 40030 extending therefrom, etc. When the outline dimension of the thermal insulation plate 40030 is equal to the outline dimension of the lower flange or cooling disk 40025, the structure is as shown in Fig. 22. The thermal insulation plate 40030 may be connected to the lower flange 4005 or the cooling disk 40025 by means of adhesion, may be connected by means of pinning or screw fixing, may be hung below the lower flange 4005 or the cooling disk 40025 by means of a connecting rod, etc. The material of the thermal insulation plate may be a graphite felt or a graphite plate or a carbon-carbon composite plate, etc.

The arrangement of the thermal insulation plate with the barrel-shaped structure may prevent volatiles from adhering to and accumulating on the side wall of the lower flange or the cooling disk, and may also play the role of adjusting the thermal insulation effect of the side wall of the lower flange or the cooling disk. By adjusting the thermal insulation effect of the side wall of the lower flange or the cooling disk, adjusting the temperature of the crystal lower through hole 4009 on the outer ring of the lower flange or the crystal lift hole 40027 on the outer ring of the cooling disk, thereby adjusting the diameter of the pulled cylindrical crystal. The function of providing the thermal insulation filler 40032 is also to adjust the thermal insulation temperature by adjusting the thickness of the added thermal insulation filler while performing the thermal insulation function, and finally to adjust the temperature of the crystal lower through hole 4009 on the outer ring of the lower flange or crystal lift hole 40027 on the outer ring of the cooling disc, and to adjust the diameter of the pulled cylindrical crystal, etc.

In practice, it is also possible to provide a thermal insulation plate on the upper panel of the lower flange or the cooling disk, namely, the outer surface of the lower flange or the cooling disk is all coated with an insulation material.

In practice, a central hole 4003002 may be disposed in the middle of the thermal insulation plate to coincide with the through hole in the central part of the cooling disk 40025. Multiple through holes 1003001 corresponding to the crystal lift holes 40027 on the cooling disk 40025 may be disposed on the periphery of the central hole. When the lower side of the lower flange or the cooling disk 40025 is provided with at least one upwardly-recessed step from the outside to the inside to form a step surface, the thermal insulation plate is then provided with at least one upwardly-raised step 4003003 from the outside to the inside, and the steps 4003003 cooperate with the step surfaces on the lower flange or the cooling disk 40025. The detailed structure is shown in Figs. 21 and 22.

In practice, the cooling medium preferably cools pure water, while other cooling gases may be selected. In practice, a cooling disk 20025 may also be disposed below the lower flange 4005 (as shown in Figs. 10 and 11). A cavity 20024 is disposed in the middle of the cooling disk 20025.

Multiple fixing columns 20026 are disposed in the cavity 20024. Crystal lift holes 20027 are respectively disposed on each fixing column 20026. The cavity 20024 communicates with a water outlet pipe 20023 and a water inlet pipe 20028 respectively. The water outlet pipe 20023 and the water inlet pipe 20028 communicate with a water inlet port and a water outlet port disposed on the lower flange 2005 or 4005.

In a particular application of the invention, it is positioned above the crucible in the furnace and the lower part of the lower flange or cooling disk of the invention is close to but not in contact with the melt in the crucible. In operation, the raw materials are firstly put into the crucible, and the heater is turned on to heat the crucible located on the lower shaft. After the raw materials in the crucible are melted into a melt, the seed crystal is driven to descend by the upper lift mechanism. After the seed crystal passes through the crystal lower through hole 2009 or the crystal lower through hole 2009 and the crystal lift hole 20027, and the through hole 100501, the seed crystal contacts with the melt and is not descended. After the lower end of the seed crystal melts, the seed crystal is slowly lifted. As the cooling medium is introduced into the lower flange or cooling disk, the melt now rises following the seed crystal. As the melt approaches the underside of the lower flange or cooling disk, the melt gradually crystallizes as the temperature therein is lower than the temperature of the crucible. As the crystallized melt enters the crystal lower through hole 2009 or the crystal lower through hole 2009 and crystal lift hole 20027, the temperature gradually decreases to form the desired columnar crystal.

In application, the cooling medium in the lower flange or the cooling disk may perform forced cooling on the cylindrical crystal just after crystallization by the crystal lower through hole 2009 or the crystal lower through hole 2009 and the crystal lift hole 20027. The thermal insulation plate disposed on the lower flange or the cooling disk may prevent volatiles from adhering to the surface of the lower flange or the cooling disk. Also, the thermal insulation effect (cold insulation effect) in each ring of the crystal lower through holes 2009 or the crystal lift holes 20027 may also be adjusted by the arrangement of the thermal insulation plate, thereby adjust the diameter of the cylindrical crystal pulled by the crystal lower through hole 2009 or the crystal lift hole 20027 in the inner and outer rings, etc.

In practice, the shape of the step 100502 disposed on the thermal insulation plate may be disposed in a circular shape or a quincunx shape formed by providing an inwardly-recessed arc between every two of the through holes 100501 or an outwardly protruding arc between every two of the through holes 100501 or various special shapes.

In the practice of the present invention, all of the cooling medium inlets and outlets referred to may be disposed in multiple groups.

The crushed silicon materials involved in the present invention not only include the residual materials occurring during the preparation of the silicon core, the silicon core which is inadvertently broken, the crushed materials produced by the polycrystalline silicon/single crystal silicon production enterprise during the process stages of reduction, cutting, grinding and polishing, etc., but also include silicon materials of other shapes (such as cauliflower materials, silicon rods with a smaller length, etc.). Or, according to the present invention, the silicon core may be directly pulled using silicon materials which are directly purchased.

In practice, this embodiment may be used not only for the pulling of silicon cores, but also for the pulling of other crystalline materials.

In this embodiment, multiple crystal cooling pipes are disposed between the upper flange and the lower flange. A cooling medium channel is disposed at the periphery of the crystal cooling pipes. A low-temperature region is formed on a space above the crucible by the cooling medium, so as to form a temperature gradient with the high temperature at the lower part and the low temperature at the upper part. It is also possible to reduce the temperature of the molten silicon liquid above the crucible, increase the viscosity of the silicon liquid, and facilitate the silicon liquid to follow the seed crystal for crystallization. Most importantly, it is also possible to cool the silicon core and thus increase the pulling speed of the silicon core.

In addition, according to this embodiment, a thermal insulation plate is disposed below the lower flange or the cooling disk, and the surface of the crystal cooling mechanism is insulated by the thermal insulation plate, so that volatile adhering to the lower surface and the side wall of the crystal cooling mechanism due to condensation phenomenon is effectively avoided. In this embodiment, while avoiding the adhesion of volatiles on the crystal cooling mechanism, due to the heat preservation function of the thermal insulation plate, the cooling of the corresponding crucible region due to the low temperature below the crystal cooling mechanism is avoided, and the crystal cooling mechanism is prevented from carrying away excessive temperature, which has the effect of reducing heating energy consumption, etc. Meanwhile, due to the heat preservation function of the thermal insulation plate, the cooling effect of the cooling medium in the crystal cooling mechanism completely acts on the inner hole wall of the crystal lift hole, thereby improving the cooling effect on the pulling crystal, realizing the rapid crystallization of the crystal, serving the purpose of improving the crystal pulling speed, etc.

### Application example of the present application

According to the present application, there is also provided an artificial crystal preparation apparatus including: a furnace body; a crucible disposed in the furnace body and disposed to be able to move up and down in the furnace body; a lifting apparatus disposed above the crucible, which is provided so as to be able to move up and down above the crucible, an end portion of the lifting apparatus being provided with a receiving portion; and a crystal cooling apparatus disposed above the crucible, the crystal cooling apparatus being provided with at least one first lift hole through which the crystal pulled from the crucible passes, end portions of the lifting apparatus being aligned with the first lift hole, respectively.

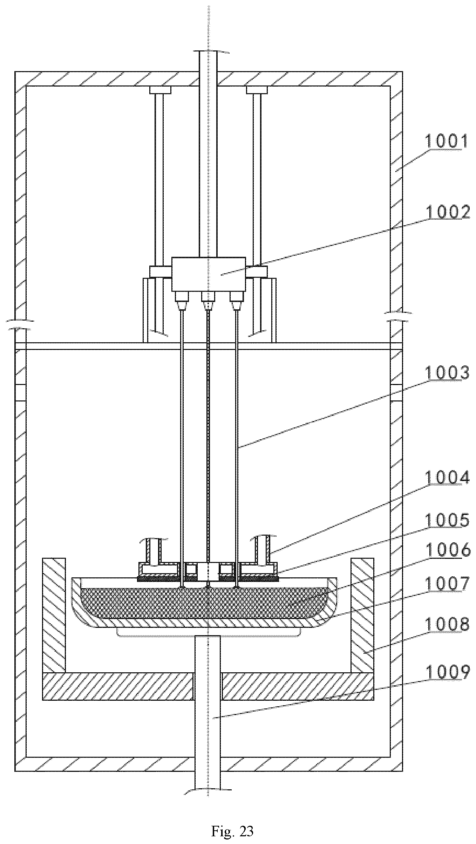

Fig. 23 illustrates an artificial crystal preparation apparatus according to one embodiment of the present application. As shown in Fig. 23, the artificial crystal preparation apparatus includes a furnace body 1001, an upper lift mechanism 1002, a crystal cooling mechanism 1004, a thermal insulation plate 1005, a crucible 1007 and a heater 1008. The upper lift mechanism 1002 corresponds to the lift apparatus in the present application. The crystal cooling mechanism 1004 is a specific example of the crystal pulling mechanism in the present application. A heater 1008 is disposed in the furnace body 1001. A thermal insulation layer is disposed between the inner wall of the furnace body 1001 and the outer edge surface of the heater 1008. A crucible 1007, which is fixed in position or is able to lift up and down, is disposed in the middle of the heater 1008. A crystal cooling mechanism 1004, which is fixed in position or is able to lift up and down, is disposed above the crucible 1007. The crucible 1007 or the crystal cooling mechanism 1004 being lifted up and down may achieve that the distance between the lower surface of the crystal cooling mechanism 1004 and the liquid surface of the melt 1006 in the crucible 1007 tends to be constant. In the specific implementation, it may be ensured that the distance between the lower surface of the crystal cooling mechanism 1004 and the liquid surface of the melt 1006 in the crucible 1007 tends to be constant by lifting the crucible 1007 up and down or lifting the crystal cooling mechanism 1004 up and down. A thermal insulation plate 1005 is disposed at the lower part of the crystal cooling mechanism 1004. Multiple crystal lower lift holes 100501 corresponding to the crystal upper lift holes 100401 on the crystal cooling mechanism 1004 on a one-to-one basis are disposed on the thermal insulation plate 100. The crystal upper lift holes are a specific example of the first lift holes in the present application. The crystal lower lift holes are a specific example of the second lift holes in the present application. An upper lift mechanism 1002 is provided above the crystal cooling mechanism 1004, and an end portion of the upper lift mechanism 1002 is provided with a receiving portion. The lower ends of the seed crystals received in the receiving portion of the upper lift mechanism 1002 are respectively aligned with the crystal upper lift hole 100401 of the crystal cooling mechanism 1004. The crystal upper lift hole 100401 is a specific example of the first lift hole of the present application. Multiple crystals may be pulled simultaneously by the cooling mechanism.

In practical applications of the present invention, the following effects can be achieved by providing a thermal insulation plate 1005.
1. With the provision of the thermal insulation plate 1005, it is possible to reduce or avoid that the cooling medium introduced causes the surface temperature of the crystal cooling mechanism 1004 to be lower than the temperature at which the volatiles adhere and deposit in the furnace, thereby reducing or avoiding that volatiles in the melt 1006 condense and adhere to the outer surface of the crystal cooling mechanism 1004.
2. The temperature uniformity of each crystal upper lift hole 100401 on the crystal cooling mechanism 1004 may be better ensured by the arrangement of the thermal insulation plate 1005 (namely, the temperature of the crystal upper lift hole 100401 on the inner ring and the crystal upper lift hole 100401 on the outer ring of the crystal cooling mechanism 1004 may be adjusted, thereby achieving that the temperature of the crystal upper lift holes 100401 on the inner ring and the outer ring tends to be isothermal).
3. The cooling effect of the cooling mechanism 1004 is weakened by providing the thermal insulation plate 1005 as at least one upwardly-recessed step to forming a step surface and by the difference in the thickness of the steps. Namely, the temperature required for central pulling is high, and the thickness of the central part of the thermal insulation plate 1005 is thick, so the cooling effect of the thermal insulation plate 1005 on the melt 1006 may be weakened. On the contrary, the temperature required for outer pulling is low, and the thickness of the edge part of the thermal insulation plate 1005 is thin, the cooling effect of the thermal insulation plate 1005 on the melt 1006 may be increased. By the arrangement of the thermal insulation plate 1005, the pulling conditions at the inside and outside tend to be the same, thereby ensuring the consistency of the crystal crystallization of the inner and outer rings, and thus ensuring the consistency of the diameter of the crystal pulled in each circle.
4. By the provision of the thermal insulation plate 1005, it is also possible to make the temperature of the crystallization region in the crucible tend to be uniform, reducing or avoiding the undesirable cooling down of the crystallization region in the crucible caused by the cooling medium in the crystal cooling mechanism 1004 (the surface temperature of the crystal cooling mechanism 1004 is low, and a part of the heat may be taken away; and the temperature decreases after the heat is lost). Furthermore, since it is ensured that the temperature of the crystallization region in the crucible does not decrease, it is not necessary to increase the heating power to ensure that the temperature of the crystallization region in the crucible does not decrease, thereby achieving the effect of reducing energy consumption (namely, by the arrangement of the thermal insulation plate 1005, it is possible to reduce or adjust the absorption of the liquid surface temperature of the melt 1006 in the crucible by the crystal cooling mechanism 1004, thereby avoiding unnecessary heat loss and an increase in power consumption, etc.).

In practice, in order to achieve that the distance between the lower surface of the crystal cooling mechanism 1004 and the liquid surface of the melt 1006 in the crucible 1007 tends to be constant, it is preferable that the crucible 1007 is raised and lowered so that the position of the crystal cooling mechanism 1004 does not move. The crucible 1007 being lifted up and down is a conventional and relatively common technical solution in the art. In particular, the lower end of the crucible 1007 may be disposed on a crucible support seat, and the lower end of the crucible support seat is connected to a lower shaft 1009 capable of being lifted and lowered. The lifting and lowering of the crucible 1007 is achieved by the lifting and lowering of the lower shaft 1009. This technical solution not only has a simple structure, but also may always ensure that the crystallization line of the crystal is unchanged (namely, the liquid level of the melt 1006 is always in a fixed position of the heater).

If the technical solution that the crystal cooling mechanism 1004 is lifted up and down while the crucible 1007 is stationary is selected, the crystal cooling mechanism 1004 is connected to the lift mechanism to realize the lifting up and down function. The crystal cooling mechanism 1004 is driven up and down by the lift mechanism. It should be noted that the lift mechanism is a conventional technique in the art, and the specific structure will not be described repeatedly herein.

In practice, the heater 1008 may also be configured to be raised and lowered. As the liquid level of the melt 1006 within the crucible 1007 decreases, the heater 1008 also decreases as the crystal cooling mechanism 1004 decreases. This also ensures that the crystallization line of the crystal does not change. Likewise, the lifting structure of the heater 1008 is also a conventional structural arrangement in the art and will not be described repeatedly herein.

Further, the crystal cooling mechanism 1004 is provided with an upper through hole 100403 in the middle thereof, and a cavity 100402 is disposed in the crystal cooling mechanism 1004. Multiple groups of fixing columns are radially disposed on the periphery of the upper through hole 100403. Each group of fixing columns includes at least two fixing columns. When implemented, the arrangement form of the plurality of groups of fixing columns is that fixing columns located on a concentric circle or fixing columns extending outwards along the same diameter may form a group. A crystal upper lift hole 100401 is respectively disposed on each fixing column. A cavity 100402 is respectively in communication with a water outlet pipe and a water inlet pipe, where the water outlet pipe and water inlet pipe are respectively connected to a cooling medium source.

Further, in order to simultaneously pull more crystal rods, multiple cycles of crystal upper lift holes 100401 are disposed on the crystal cooling mechanism 1004 at intervals from the outer edge to the inside. At this time, in order to ensure the consistency of the diameter of the crystal pulled by the crystal upper lift hole 100401 in each circle, it is necessary to overcome the problem that the temperature distribution of the melt in the crucible 1007 is not uniform. Therefore, a step surface of at least one upwardly-recessed step is provided from the outside to the inside below the crystal cooling mechanism 1004, and a ring of crystal upper lift holes 100401 are respectively disposed on each step surface.

The specific structure relating to the crystal cooling mechanism 1004 may employ the cooling apparatus according to the second embodiment of the present application, which will be described later.

A lower through hole 100503 is disposed in the middle of the thermal insulation plate 1005, and multiple groups of crystal lower lift holes 100501 are radially disposed on the periphery of the lower through hole 100503. The lower through holes 100503 and the crystal lower lift holes 100501 correspond to the upper through holes 100403 and the crystal upper lift holes 100401 on the crystal cooling mechanism 1004, respectively.

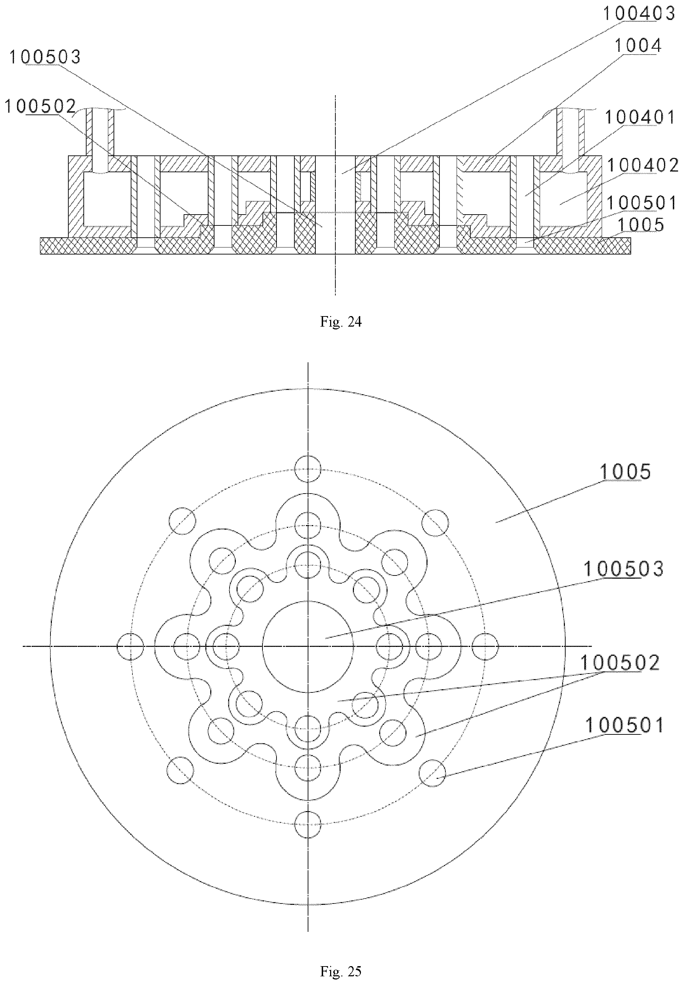

According to a preferred example of the present application, as shown in Figs. 23 and 24, the thermal insulation plate 1005 has a plate-type structure. The outline dimension of the thermal insulation plate 1005 is greater than or equal to the outline dimension of the crystal cooling mechanism 1004.

According to another preferred example of the present application, as shown in Fig. 24, the thermal insulation plate 1005 has a plate-type structure, and at least one upwardly-raised step 100502 is disposed on the upper side of the thermal insulation plate 1005 from the outside to the inside. The step 100502 is matched with the step surface on the lower portion of the crystal cooling mechanism 1004.

According to still another preferred embodiment of the present application, an alternative structural form of the thermal insulation plate 1005 is a barrel-type structure in which the middle portion of the thermal insulation plate 1005 is recessed downwards to form a groove, the inner edge surface of which is in clearance fit or interference fit with the outer edge surface of the crystal cooling mechanism 1004.

According to still another preferred embodiment of the present application, when the thermal insulation plate 1005 is disposed in a barrel-type structure, at least one upwardly-raised step 100502 is disposed on the upper surface of the thermal insulation plate 1005 from the outside to the inside. The step 100502 is matched with the step surface on the lower portion of the crystal cooling mechanism 1004.

When the outer edge surface of the crystal cooling mechanism 1004 is in clearance fit with the inner edge surface of the groove, a thermal insulation filler is disposed in the clearance. The thermal insulation filler is any one of a quartz felt or a graphite felt or a zirconium felt.

The thermal insulation plate 1005 with a barrel-shaped structure may serve to prevent volatiles from adhering to and accumulating on the side wall of the crystal cooling mechanism 1004, and may also serve to adjust the heat preservation effect of the side wall of the crystal cooling mechanism 1004. By adjusting the heat preservation effect of the side wall of the crystal cooling mechanism 1004, the temperature of the crystal upper lift hole 100401 on the outer ring of the crystal cooling mechanism 1004 is adjusted, thereby adjusting the diameter of the pulled cylindrical crystal 1003. The function of providing the thermal insulation filler is also to adjust the thermal insulation temperature by adjusting the thickness of the added thermal insulation filler while performing the thermal insulation function, and finally to adjust the temperature of the crystal upper lift holes 100401 on the outer ring of the crystal cooling mechanism 1004 so as to adjust the diameter of the pulled cylindrical crystal 1003, etc.

The lower portion of the crystal cooling mechanism 1004 is provided with a step surface of at least one upwardly-recessed step from the outside to the inside, and a thermal insulation plate 1005 conforming to the shape of the step surface is disposed below the step surface. When implemented, the step may better ensure the temperature uniformity of the crystal upper lift hole 100401 on the crystal cooling mechanism 1004. Since the temperature distribution range of the crucible is that the peripheral temperature is higher than the central temperature, when pulling the crystal, the cooling range of the crystal cooling mechanism 1004 should be changed accordingly, so as to ensure the consistency of crystal crystallization in the inner and outer circles.

As shown in Fig. 1, the thermal insulation plate 1005 has a plate-type structure. The outline dimension of the thermal insulation plate 1005 is greater than or equal to the outline dimension of the lower flange or cooling disc of the crystal cooling mechanism 1004. That is, according to a preferred embodiment of the present application, the outline dimension of the thermal insulation plate 1005 is greater than the outer dimension of the crystal cooling mechanism 1004, and the outer edge of the thermal insulation plate 1005 extends outwards. Thus, the adhesion of volatiles to the outer edge of the crystal cooling mechanism 1004 may be reduced or avoided, and also the thermal insulation plate 1005 may function as a tray, so that volatiles fall on the upper surface of the thermal insulation plate 1005 extending out, etc.

According to still another preferred embodiment of the present application, the outline dimension of the thermal insulation plate 1005 is equal to the outline dimension of the crystal cooling mechanism 1004. When the thermal insulation plate 1005 is connected to the crystal cooling mechanism 1004, the thermal insulation plate 1005 and the crystal cooling mechanism 1004 may be connected by means of adhesion, may be connected by means of pin or screw fixation, may be hung below the crystal cooling mechanism 1004 by means of a connecting rod, etc.

The material of the thermal insulation plate 1005 may be a graphite felt or a graphite plate or a carbon-carbon composite plate, etc.

In practice, a thermal insulation plate may also be disposed on the upper panel of the crystal cooling mechanism 1004, i.e., the entire outer surface of the crystal cooling mechanism 1004 is coated with a layer of thermal insulation material.

In implementation, a lower through hole 100503 corresponding to the through hole in the central portion of the crystal cooling mechanism 1004 may be disposed in the middle of the thermal insulation plate 1005. The multiple crystal lower lift holes 100501 corresponding to the crystal upper lift holes 100401 on the crystal cooling mechanism 1004 may be disposed on the periphery of the lower through hole 100503. When the lower face of the crystal cooling mechanism 1004 forms a step surface by providing at least one stage of upwardly-recessed steps from the outside to the inside, the thermal insulation plate 1005 is then provided with at least one stage of upwardly-raised steps 100502 from the outside to the inside, and the steps 100502 cooperate with the step surface on the crystal cooling mechanism 1004, and the detailed structure is shown in Fig. 24.

The cooling medium referred to in the present invention is cooling water or cooling oil or a cooling gas such as liquid nitrogen.

In a specific application of the present invention, the thermal insulation plate 1005 is positioned above the crucible 1007 in the furnace 1001, and the underside of the crystal cooling mechanism 1004 is close to but not in contact with the melt 1006 in the crucible 1007. In operation, the raw materials are firstly put into the crucible 1007, and the heater 1008 is turned on to heat the crucible 1007 located on the lower shaft 1009. After the raw materials in the crucible 1007 are melted into the melt 1006, the seed crystal is driven to descend by the upper lift mechanism 1003. The seed crystal passes through the crystal upper lift hole 100401 and the crystal lower lift hole 100501 and contacts with the melt 1006, the descent of the seed crystal is stopped. After the lower end of the seed crystal has melted, the seed crystal is slowly lifted, at which time the melt 1006 follows the seed crystal as it rises. As the melt approaches the underside of the crystal cooling mechanism 1004, the melt 1006 gradually crystallizes as the temperature therein is lower than the temperature of the crucible 1007 due to the cooling medium introduced into the crystal cooling mechanism 1004. The desired columnar crystals 1003 are formed as the crystallized melt enters the crystal upper lift hole 100401 and the temperature gradually decreases. In use, the cooling medium in the crystal cooling mechanism 1004 is forced by the crystal upper lift hole 100401 to cool the just-crystallized cylindrical crystal 1003. The thermal insulation plate 1005 disposed on the crystal cooling mechanism 1004 may prevent volatiles from adhering to the surface of the crystal cooling mechanism 1004, and also may also adjust the thermal insulation effect (cooling insulation effect) of each ring of crystal upper lift holes 100401, thereby adjusting the diameter of the cylindrical crystal 1003 pulled by the crystal upper lift holes 100401 in the inner and outer ring, etc.

In practice, the shape of the step 100502 disposed on the thermal insulation plate 1005 may be disposed in a circular shape, or may be formed in a quincunx shape by providing an inwardly-recessed circular arc between every two crystal lower lift holes 100501 (the specific structure is shown in Fig. 25), or in a flower shape by providing an outwardly protruding arc between every two crystal lower lift holes 100501, or in other various shapes.

In the practice of the present invention, all of the cooling medium inlets and outlets referred to may be disposed in multiple groups.

In practice, the invention may be used not only for the pulling of silicon cores and silicon rods, but also for the pulling of other crystalline materials.

According to this embodiment, by providing the thermal insulation plate below the crystal cooling mechanism so that the surface of the crystal cooling mechanism is insulated by the thermal insulation plate, the adhesion of volatiles to the lower surface and the side wall of the crystal cooling mechanism due to condensation is effectively avoided. In the present invention, while avoiding the adhesion of volatiles to the crystal cooling mechanism, due to the heat preservation function of the thermal insulation plate, the temperature reduction of the crucible area corresponding to the lower surface of the crystal cooling mechanism due to the low temperature of the lower surface of the crystal cooling mechanism is avoided, the crystal cooling mechanism is prevented from carrying away excessive temperature, and the heating energy consumption is reduced, etc. Meanwhile, due to the heat preservation function of the thermal insulation plate, the cooling effect of the cooling medium in the crystal cooling mechanism completely acts on the inner hole wall of the crystal upper lift hole, thereby improving the cooling effect on the pulled crystal, realizing the rapid crystallization of the crystal, serving the purpose of improving the crystal pulling speed, etc.

The present application is mainly applied to a silicon core furnace for pulling the silicon core by crushed silicon material.

The above mentioned are merely preferred embodiments of the invention and not intended to limit the invention. The examples of the invention may be combined with each other and the invention may have various modifications and changes for those skilled in the art. Any modifications, equivalents, improvements, etc. within the spirit and principles of this invention are intended to be included within the scope of this invention.

## Claims

1. A crystal cooling apparatus for simultaneously pulling multiple crystals, **characterized in that** the crystal cooling apparatus is provided with multiple first lift holes for pulled crystals to pass through and a cooling medium channel for cooling the crystals.

2. The crystal cooling apparatus for simultaneously pulling multiple crystals according to claim 1, **characterized in that** the crystal cooling apparatus comprises an upper flange (2003) and a lower flange (2005), and a crystal cooling pipe (2007) disposed between the upper flange (2003) and the lower flange (2005); one end of the crystal cooling pipe (2007) is connected to the upper flange (2003), the other end of the crystal cooling pipe (2007) being connected to the lower flange (2005); the crystal cooling pipe (2007) forms the first lift hole; and the cooling medium channel is disposed at the periphery of the crystal cooling pipe (2007).

3. The crystal cooling apparatus for simultaneously pulling multiple crystals according to claim 2, **characterized in that** a water outlet (2002) and a water inlet (2006) for access of a cooling medium for cooling the crystals are disposed on the upper flange (2003) or the lower flange (2005).

4. The crystal cooling apparatus for simultaneously pulling multiple crystals according to claim 2, **characterized in that** the upper flange (2003) is provided with a crystal upper through hole (2001) penetrating through the upper flange (2003), the crystal upper through hole (2001) being provided corresponding to the first lift hole.

5. The crystal cooling apparatus for simultaneously pulling multiple crystals according to claim 2, **characterized in that** an upwardly-recessed groove is disposed at a lower surface of the upper flange (2003), or a downwardly-recessed groove is disposed at an upper surface of the upper flange (2003); a lower cover plate (20017) is disposed at an open end of the groove; the lower cover plate (20017) and the groove form a water inlet chamber (20011); a crystal upper through hole (2001) penetrating through the upper flange (2003) is disposed at a groove bottom of the groove; and the crystal upper through hole (2001) is disposed corresponding to the first lift hole; and multiple through holes are disposed on the lower cover plate (20017).

6. The crystal cooling apparatus for simultaneously pulling multiple crystals according to claim 2, **characterized in that** upper grooves and lower grooves are respectively disposed at the upper and lower surfaces of the upper flange (2003); a cover plate (20018) for the water inlet chamber and a cover plate (20021) for a water return chamber are respectively disposed at an open ends of the upper grooves and the lower grooves; the cover plate (20018) for the water inlet chamber and the upper groove form a water inlet chamber (20011); the cover plate (20021) for the water return chamber and the lower groove form a water return chamber (20020); a crystal upper through hole (2001) penetrating to the groove bottom of the lower groove, a water outlet (2002) and a water inlet (2006) are respectively disposed on the cover plate (20018) for the water inlet chamber ; the crystal upper through hole (2001) is disposed corresponding to the first lift hole; the groove bottom of the upper groove is provided with a water inlet hole penetrating to the groove bottom of the lower groove; the water inlet chamber (20011) communicates with the water inlet (2006); the water return chamber (20020) communicates with the water outlet (2002); and multiple through holes are disposed on the cover plate (21) for the water return chamber.

7. The crystal cooling apparatus for simultaneously pulling multiple crystals according to claim 2, **characterized in that** the upper flange (2003) comprises an upper disc, a middle disc and a lower disc which are stacked to form a flange body; a middle hole (20034) penetrating through the flange body is disposed at the middle of the upper surface of the flange body; a hollow water return chamber (20020) is disposed at an upper portion of the flange body; a hollow water inlet chamber (20011) is disposed at a lower portion of the flange body; a connecting pipe (20019) penetrating to the water inlet chamber (20011) is disposed on the upper surface of the flange body, the connecting pipe (20019) forming a water inlet (2006); a water outlet (2002) penetrating to the water return chamber (20020) is disposed on the upper surface of the flange body; a water return transition pipe (20030) penetrating to the water return chamber (20020) is disposed on the lower surface of the flange body; a crystal upper through hole (2001) penetrating through the flange plate is disposed at the upper surface of the flange body at the periphery of the middle hole (20034); and the crystal upper through hole (2001) is arranged corresponding to the first lift hole.

8. The crystal cooling apparatus for simultaneously pulling multiple crystals according to claim 7, **characterized in that** a transition ring (20033) is disposed at the lower surface of the flange body; a middle hole (20034) is disposed at the middle of the transition ring (20033); and a crystal upper through hole (2001), a water outlet opening and a water return opening are disposed at the upper surface of the transition ring (20033), respectively.

9. The crystal cooling apparatus for simultaneously pulling multiple crystals according to claim 2, **characterized in that** the lower flange (2005) is provided with a crystal lower through hole (2009) penetrating through the lower flange (2005); and the crystal lower through hole (2009) is disposed corresponding to the first lift hole.

10. The crystal cooling apparatus for simultaneously pulling multiple crystals according to claim 2, **characterized in that** a downwardly-recessed groove is disposed at an upper surface of the lower flange (2005); an upper cover plate (20015) is disposed at an open end of the groove; the groove and the upper cover plate (20015) form a water collection chamber (20016); a crystal lower through hole (2009) penetrating to below the lower flange (2005) is disposed at a groove bottom of the groove; the crystal lower through hole (2009) is disposed corresponding to the first lift hole; and multiple through holes are disposed on the upper cover plate (20015).

11. The crystal cooling apparatus for simultaneously pulling multiple crystals according to any one of claims 2 to 10, **characterized in that** a cooling disk (20025) is disposed below the lower flange (2005); a cavity (20024) is disposed in the cooling disk (20025); and the cooling disk (20025) are provided with crystal lift holes (20027) disposed corresponding to the crystal lower through holes (2009) and a water outlet hole and a water inlet hole respectively communicating with the cavity (20024).

12. The crystal cooling apparatus for simultaneously pulling multiple crystals according to any one of claims 2 to 10, **characterized in that** a connection cylinder (2004) is disposed between the upper flange (2003) and the lower flange (2005); the crystal cooling pipe (2007) is disposed inside the connection cylinder (2004); one end of the crystal cooling pipe (2007) is connected to a crystal upper through hole (2001) disposed on the upper flange (2003), the other end of the crystal cooling pipe (2007) being connected to a crystal lower through hole (2009) disposed on the lower flange (2005); and the cooling medium channel is formed by a cavity among an inner edge surface of the connection cylinder (2004), the lower end surface of the upper flange (2003) and the upper end surface of the lower flange (2005).

13. The crystal cooling apparatus for simultaneously pulling multiple crystals according to any one of claims 2 to 10, **characterized in that** a bushing (20013) is sleeved at the periphery of the crystal cooling pipe (2007); one end of the bushing (20013) communicates with a water inlet chamber (20011) disposed in the upper flange (2003), the other end of the bushing (20013) being in communication with a water collection chamber (20016) disposed in the lower flange (2005); the cooling medium channel is formed by a cooling chamber (20012) between an inner edge surface of the bushing (20013) and an outer edge surface of the crystal cooling pipe (2007), the water inlet chamber (20011) and the water collection chamber (20016).

14. The crystal cooling apparatus for simultaneously pulling multiple crystals according to any one of claims 2 to 10, **characterized in that** a bushing (200213) is sleeved on the periphery of the crystal cooling pipe (2007); a downwardly-recessed semicircular step (20022) is disposed on an upper end of the bushing (20013), and the upper end of the bushing (20013) communicates with a water inlet chamber (20011) disposed on the upper flange (2003); an upper end of the semicircular step (20022) communicates with a water return chamber (20020) disposed at a lower part of the upper flange (2003); a lower end of the bushing (200213) communicates with a water collection chamber (20016) disposed at the upper part of the lower flange (2005) or connects to the lower flange (2005); the cooling medium channel is formed by a cooling chamber between an inner edge surface of the bushing (20013) and an outer edge surface of the crystal cooling pipe (2007), the water inlet chamber (20011), the water return chamber (20020) and the water collection chamber (20016).

15. The crystal cooling apparatus for simultaneously pulling multiple crystals according to claim 13 or 14, **characterized in that** a separator (20029) is disposed in the cooling chamber (20012) between the crystal cooling pipe (2007) and the bushing (20013).

16. The crystal cooling apparatus for simultaneously pulling multiple crystals according to any one of claims 2 to 10, **characterized in that** the crystal cooling apparatus is provided with multiple crystal cooling pipes (2007); one of the crystal cooling pipes (2007) is disposed in the middle of the crystal cooling apparatus, and multiple groups of crystal cooling pipes (2007) are radially disposed at the periphery of the crystal cooling pipe (2007) in the middle, each group of crystal cooling pipes (2007) comprising at least two crystal cooling pipes (2007); or a middle hole (20034) is disposed in the middle of the crystal cooling apparatus, and multiple groups of crystal cooling pipes (2007) are radially disposed on the periphery of the middle hole (20034), each group of crystal cooling pipes (2007) comprising at least two crystal cooling pipes (2007).

17. The crystal cooling apparatus for simultaneously pulling multiple crystals according to claim 7 or 8, **characterized in that** a connection cylinder (2004) and an inner connection cylinder (20031) are respectively provided between the flange body and the lower flange (2005); the crystal cooling pipe (2007) is disposed in a cavity between the connection cylinder (2004) and the inner connection cylinder (20031); an upper end of the crystal cooling pipe (2007) is connected to a crystal upper through hole (2001) disposed on the flange body, and a lower end of the crystal cooling pipe (2007) is connected to a crystal lower through hole (2009) disposed on the lower flange (2005); and the cooling medium channel is formed by a cavity among an inner edge surface of the connection cylinder (2004) and a lower end surface of the upper flange (2003), an upper end surface of the lower flange (2005), and an outer edge surface of the inner connection cylinder (20031).

18. The crystal cooling apparatus for simultaneously pulling multiple crystals according to claim 12 or 17, **characterized in that** a water outlet (2002) and a water inlet (2006) for access of a cooling medium for cooling the crystals are disposed on the connection cylinder.

19. The crystal cooling apparatus for simultaneously pulling multiple crystals according to claim 17, **characterized in that** a cooling disk (20025) is disposed below the lower flange (2005); a cavity (20024) is disposed in the cooling disk (20025); the cooling disk (20025) is provided with crystal lift hole (20027) disposed corresponding to the crystal lower through holes (2009) and a water outlet hole and a water inlet hole respectively communicating with the cavity (20024); the water inlet hole is connected to a lower end of a water inlet pipe (20028); an upper end of the water inlet pipe (20028) passes through the lower flange (2005) and is connected to a water outlet below the flange body; the water outlet hole is connected to a lower end of a water outlet pipe (20023); and an upper end of the water outlet pipe (20023) passes through the lower flange (2005) and communicates with the cooling medium channel on the flange body.

20. The crystal cooling apparatus for simultaneously pulling multiple crystals according to claim 2, **characterized in that** the crystal cooling apparatus further comprises a thermal insulation plate (40030) disposed below the lower flange (4005); and the thermal insulation plate (40030) is provided with at least one second lift hole disposed in one-to-one correspondence with the crystal lower through hole (4009) of the lower flange (4005).

21. The crystal cooling apparatus for simultaneously pulling multiple crystals according to claim 1, **characterized in that** the crystal cooling apparatus further comprises a thermal insulation plate (40030) disposed below the cooling disk (40025); the thermal insulation plate (40030) is provided with at least one second lift hole; and the second lift hole is disposed in one-to-one correspondence with the crystal lift hole (40027) of the cooling disk (40025).

22. The crystal cooling apparatus for simultaneously pulling multiple crystals according to claim 20 or 21, **characterized in that** a central hole (4003002) is formed at the middle of the thermal insulation plate (40030); and the second lift holes are radially disposed at a periphery of the central hole (4003002).

23. The crystal cooling apparatus for simultaneously pulling multiple crystals according to claim 20 or 21, **characterized in that** an outline dimension of the thermal insulation plate (40030) is greater than or equal to an outline dimension of the lower flange (4005) or the cooling disk (40025).

24. The crystal cooling apparatus for simultaneously pulling multiple crystals according to claim 20 or 21, **characterized in that** an upwardly-raised step (4003003) is disposed from the outside to the inside on an upper surface of the thermal insulation plate (40030), the step (4003003) corresponding to the stepped surface on the lower surface of the lower flange (4005) or on the lower surface of the cooling disk (40025).

25. The crystal cooling apparatus for simultaneously pulling multiple crystals according to claim 20 or 21, **characterized in that** the thermal insulation plate (40030) is provided with a downwardly-recessed groove in the middle to form a barrel-type structure; and an inner edge surface of the groove is in clearance fit or interference fit with an outer edge surface of the lower flange (4005) or the cooling disk (40025).

26. The crystal cooling apparatus for simultaneously pulling multiple crystals according to claim 25, **characterized in that** a thermal insulation filler (40032) is disposed at a gap when an inner edge surface of the groove is in clearance fit with an outer edge surface of the lower flange (4005) or the cooling disk (40025).

27. The crystal cooling apparatus for simultaneously pulling multiple crystals according to claim 11, **characterized in that** the cooling disk (40025) is provided with an upper through hole at the middle thereof; a cavity (40024) is disposed in the cooling disk (40025); and the multiple crystal lift holes (40027) are radially disposed at a periphery of the upper through hole.

28. The crystal cooling apparatus for simultaneously pulling multiple crystals according to claim 11, **characterized in that** a lower surface of the lower flange (4005) or the cooling disk (40025) is provided with a stepped surface formed by providing an upwardly-recessed step from the outside to the inside; and a circle of the crystal lift holes (40027) are disposed on each stepped surface.

29. An artificial crystal preparation device, **characterized in that** the device comprises the crystal cooling apparatus according to any one of claims 1 to 28.
